(19) Europäisches Patentamt
European Patent Office
Office européen des brevets

(11) **EP 3 605 609 A1**

(12) **EUROPEAN PATENT APPLICATION**
published in accordance with Art. 153(4) EPC

(43) Date of publication:
**05.02.2020 Bulletin 2020/06**

(21) Application number: **18777860.0**

(22) Date of filing: **28.03.2018**

(51) Int Cl.:
**H01L 27/146** *(2006.01)* **H04N 5/369** *(2011.01)*

(86) International application number:
**PCT/JP2018/012987**

(87) International publication number:
**WO 2018/181585 (04.10.2018 Gazette 2018/40)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **28.03.2017 JP 2017063652**

(71) Applicant: **Nikon Corporation**
**Tokyo 108-6290 (JP)**

(72) Inventors:
• **SEO, Takashi**
**Tokyo 108-6290 (JP)**

• **TAKAGI, Toru**
**Tokyo 108-6290 (JP)**
• **NAKAYAMA, Satoshi**
**Tokyo 108-6290 (JP)**
• **ANDO, Ryoji**
**Tokyo 108-6290 (JP)**
• **KATO, Shutaro**
**Tokyo 108-6290 (JP)**

(74) Representative: **Hoffmann Eitle**
**Patent- und Rechtsanwälte PartmbB**
**Arabellastraße 30**
**81925 München (DE)**

(54) **IMAGING ELEMENT AND IMAGING DEVICE**

(57)    An image sensor includes: a photoelectric conversion unit that photoelectrically converts incident light and generates electric charge; a reflection prevention portion that prevents reflection of at least a portion of light passing through the photoelectric conversion unit; and a reflecting portion that reflects a portion of light passing through the photoelectric conversion unit toward the photoelectric conversion unit.

FIG.9

EP 3 605 609 A1

## Description

TECHNICAL FIELD

The present invention relates to an image sensor and to an imaging device.

BACKGROUND ART

An image sensor is per se known (refer to PTL1) in which a reflecting portion is provided below a photoelectric conversion unit, and in which light that has passed through the photoelectric conversion unit is reflected back to the photoelectric conversion unit by this reflecting portion. However, with a prior art image sensor, light that has passed through the photoelectric conversion unit may be reflected back by some portion other than the reflecting portion that is provided for reflection.

CITATION LIST

PATENT LITERATURE

PTL 1: Japanese Laid-Open Patent Publication No. 2016-127043.

SUMMARY OF INVENTION

According to the 1st aspect of the present invention, an image sensor, comprises: a photoelectric conversion unit that photoelectrically converts incident light and generates electric charge; a reflection prevention portion that prevents reflection of at least a portion of light passing through the photoelectric conversion unit; and a reflecting portion that reflects a portion of light passing through the photoelectric conversion unit toward the photoelectric conversion unit.

According to the 2nd aspect of the present invention, an imaging device comprises: an image sensor described below; and a control unit that, based upon a signal outputted from the first pixel and a signal outputted from the second pixel of the image sensor that captures an image formed by an optical system having a focusing lens, controls a position of the focusing lens so that the image formed by the optical system is focused upon the image sensor. The image sensor is the image sensor according to the 1st aspect, and comprises: a first pixel and a second pixel each of which comprises the photoelectric conversion unit and the reflecting portion, wherein: the first pixel and the second pixel are arranged along a first direction; at least a part of the reflecting portion of the first pixel is provided in a region more toward the first direction than a center of the photoelectric conversion unit of the first pixel; and at least a part of the reflecting portion of the second pixel is provided in a region more toward a direction opposite to the first direction than a center of the photoelectric conversion unit of the second pixel.

According to the 3rd aspect of the present invention, an imaging device, comprises: an image sensor described below; and a control unit that, based upon a signal outputted from the first pixel, a signal outputted from the second pixel, and a signal outputted from the third pixel of the image sensor that captures an image formed by an optical system having a focusing lens, controls a position of the focusing lens so that the image formed by the optical system is focused upon the image sensor. The image sensor is the image sensor according to the 1st aspect, and comprises: a first pixel and a second pixel each of which comprises the photoelectric conversion unit and the reflecting portion, wherein: the first pixel and the second pixel are arranged along a first direction; at least a part of the reflecting portion of the first pixel is provided in a region more toward the first direction than a center of the photoelectric conversion unit of the first pixel; and at least a part of the reflecting portion of the second pixel is provided in a region more toward a direction opposite to the first direction than a center of the photoelectric conversion unit of the second pixel. 11. And the image sensor further comprises: a third pixel comprising the photoelectric conversion unit and the reflection prevention portion.

BRIEF DESCRIPTION OF DRAWINGS

[Fig. 1] Fig. 1 is a figure showing the structure of principal portions of a camera;
[Fig. 2] Fig. 2 is a figure showing an example of focusing areas;
[Fig. 3] Fig. 3 is an enlarged figure showing a portion of an array of pixels upon an image sensor;
[Fig. 4] Fig. 4(a) is an enlarged sectional view of an example of an imaging pixel, and Figs. 4(b) and 4(c) are enlarged sectional views of examples of focus detection pixels;
[Fig. 5] Fig. 5 is a figure for explanation of ray bundles incident upon focus detection pixels;
[Fig. 6] Fig. 6 is an enlarged sectional view of focus detection pixels and an imaging pixel according to a first embodiment;
[Fig. 7] Fig. 7(a) and Fig. 7(b) are enlarged sectional views of focus detection pixels according to a second embodiment;
[Fig. 8] Fig. 8(a) and Fig. 8(b) are enlarged sectional views of focus detection pixels according to a third embodiment;
[Fig. 9] Fig. 9(a) and Fig. 9(b) are enlarged sectional views of focus detection pixels according to a fourth embodiment;
[Fig. 10]Fig. 10 is an enlarged view of a part of an array of pixels on an image sensor according to a fifth embodiment; and
[Fig. 11]Fig. 11 is an enlarged sectional view of focus detection pixels and an imaging pixel according to the fifth embodiment.

## DESCRIPTION OF EMBODIMENTS

### Embodiment One

An image sensor (an imaging element), a focus detection device, and an imaging device (an image-capturing device) according to an embodiment will now be explained with reference to the drawings. An interchangeable lens type digital camera (hereinafter termed the "camera 1") will be shown and described as an example of an electronic device to which the image sensor according to this embodiment is mounted, but it would also be acceptable for the device to be an integrated lens type camera in which the interchangeable lens 3 and the camera body 2 are integrated together.

Moreover, the electronic device is not limited to being a camera 1; it could also be a smart phone, a wearable terminal, a tablet terminal or the like that is equipped with an image sensor.

### Structure of the Principal Portions of the Camera

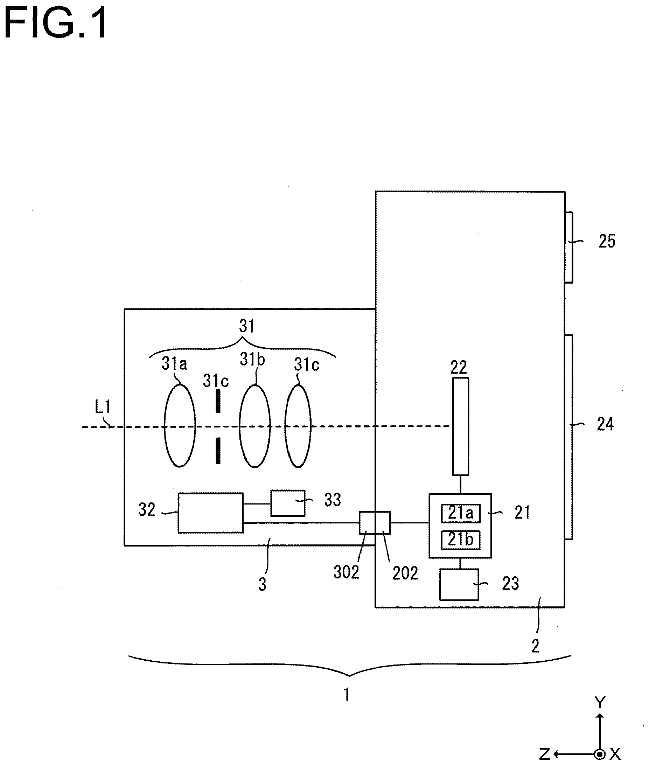

Fig. 1 is a figure showing the structure of principal portions of the camera 1. The camera 1 comprises a camera body 2 and an interchangeable lens 3. The interchangeable lens 3 is installed to the camera body 2 via a mounting portion not shown in the figures. When the interchangeable lens 3 is installed to the camera body 2, a connection portion 202 on the camera body 2 side and a connection portion 302 on the interchangeable lens 3 side are connected together, and communication between the camera body 2 and the interchangeable lens 3 becomes possible.

Referring to Fig. 1, light from the photographic subject is incident in the -Z axis direction in Fig. 1. Moreover, as shown by the coordinate axes, the direction orthogonal to the Z axis and outward from the drawing paper will be taken as being the +X axis direction, and the direction orthogonal to the Z axis and to the X axis and in the upward direction will be taken as being the +Y axis direction. In the various subsequent figures, coordinate axes that are referred to the coordinate axes of Fig. 1 will be shown, so that the orientations of the various figures can be understood.

### The Interchangeable Lens

The interchangeable lens 3 comprises an imaging optical system (i.e. an image formation optical system) 31, a lens control unit 32, and a lens memory 33. The imaging optical system 31 may include, for example, a plurality of lenses 31a, 31b and 31c that include a focus adjustment lens (i.e. a focusing lens) 31c, and an aperture 31d, and forms an image of the photographic subject upon an image formation surface of an image sensor 22 that is provided to the camera body 2.

On the basis of signals outputted from a body control unit 21 of the camera body 2, the lens control unit 32 adjusts the position of the focal point of the imaging optical system 31 by shifting the focus adjustment lens 31c forwards and backwards along the direction of the optical axis L1. The signals outputted from the body control unit 21 during focus adjustment include information specifying the shifting direction of the focus adjustment lens 31c and its shifting amount, its shifting speed, and so on.

Moreover, the lens control unit 32 controls the aperture diameter of the aperture 31d on the basis of a signal outputted from the body control unit 21 of the camera body 2.

The lens memory 33 is, for example, built by a non-volatile storage medium and so on. Information relating to the interchangeable lens 3 is recorded in the lens memory 33 as lens information. For example, information related to the position of the exit pupil of the imaging optical system 31 is included in this lens information. The lens control unit 32 performs recording of information into the lens memory 33 and reading out of lens information from the lens memory 33.

### The Camera Body

The camera body 2 comprises the body control unit 21, the image sensor 22, a memory 23, a display unit 24, and a actuation unit 25. The body control unit 21 is built by a CPU, ROM, RAM and so on, and controls the various sections of the camera 1 on the basis of a control program.

The image sensor 22 is built by a CCD image sensor or a CMOS image sensor. The image sensor 22 receives a ray bundle (a light flux) that has passed through the exit pupil of the imaging optical system 31 upon its image formation surface, and an image of the photographic subject is photoelectrically converted (image capture). In this photoelectric conversion process, each of a plurality of pixels that are disposed at the image formation surface of the image sensor 22 generates an electric charge that corresponds to the amount of light that it receives. And signals due to the electric charges that are thus generated are read out from the image sensor 22 and sent to the body control unit 21.

It should be understood that both image signals and signals for focus detection are included in the signals generated by the image sensor 22. The details of these image signals and of these focus detection signals will be described hereinafter.

The memory 23 is, for example, built by a recording medium such as a memory card or the like. Image data and audio data and so on are recorded in the memory 23. The recording of data into the memory 23 and the reading out of data from the memory 23 are performed by the body control unit 21. According to commands from the body control unit 21, the display unit 24 displays an image based upon the image data and information related to photography such as the shutter speed, the aperture value and so on, and also displays a menu actuation screen or the like. The actuation unit 25 includes a release button, a video record button, setting switches of various types and so on, and outputs actuation signals respectively corresponding to these actuations to the body control unit 21.

Moreover, the body control unit 21 described above includes a focus detection unit 21a and an image generation unit 21b. The focus detection unit 21a detects the focusing position of the focus adjustment lens 31c for focusing an image formed by the imaging optical system 31 upon the image formation surface of the image sensor 22. The focus detection unit 21a performs focus detection processing required for automatic focus adjustment (AF) of the imaging optical system 31. A simple explanation of the flow of focus detection processing will now be given. First, on the basis of the focus detection signals read out from the image sensor 22, the focus detection unit 21a calculates the amount of defocusing by a pupil-split type phase difference detection method. In concrete terms, an amount of image deviation of images due to a plurality of ray bundles that have passed through different regions of the pupil of the imaging optical system 31 is detected, and the amount of defocusing is calculated on the basis of the amount of image deviation that has thus been detected. Then the focus detection unit 21a calculates a shifting amount for the focus adjustment lens 31c to its focused position on the basis of this amount of defocusing that has thus been calculated.

And the focus detection unit 21a makes a decision as to whether or not the amount of defocusing is within a permitted value. If the focus detection unit 21 a determines that the amount of defocusing is within the permitted value, then the focus detection unit 21a determines that the system is adequately focused, and the focus detection process terminates. On the other hand, if the amount of defocusing is greater than the permitted value, then the focus detection unit 21 determines that the system is not adequately focused, and sends the calculated shifting amount for shifting the focus adjustment lens 31c and a lens shift command to the lens control unit 32 of the interchangeable lens 3, and then the focus detection process terminates. And, upon receipt of this command from the focus detection unit 21a, the lens control unit 32 performs focus adjustment automatically by causing the focus adjustment lens 31c to shift according to the calculated shifting amount.

On the other hand, the image generation unit 21b of the body control unit 21 generates image data related to the image of the photographic subject on the basis of the image signals read out from the image sensor 22. Moreover, the image generation unit 21b performs predetermined image processing upon the image data that it has thus generated. This image processing may, for example, include per se known image processing such as tone conversion processing, color interpolation processing, contour enhancement processing, and so on.

Explanation of the Image sensor

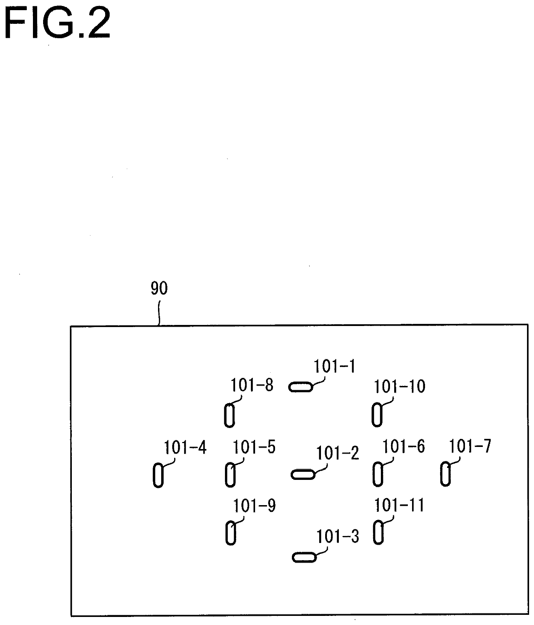

Fig. 2 is a figure showing an example of focusing areas defined in a photographic scene 90. These focusing areas are areas for which the focus detection unit 21a detects amounts of image deviation described above as phase difference information, and they may also be termed "focus detection areas", "range-finding points", or "auto focus (AF) points". In this embodiment, eleven focusing areas 101-1 through 110-11 are provided in advance within the photographic scene 90, and the camera is capable of detecting the amounts of image deviation in these eleven areas. It should be understood that this number of focusing areas 101-1 through 101-11 is only an example; there could be more than eleven such areas, or fewer. It would also be acceptable to set the focusing areas 101-1 through 101-11 over the entire photographic scene 90.

The focusing areas 101-1 through 101-11 correspond to the positions at which focus detection pixels 11, 13 are disposed, as will be described hereinafter.

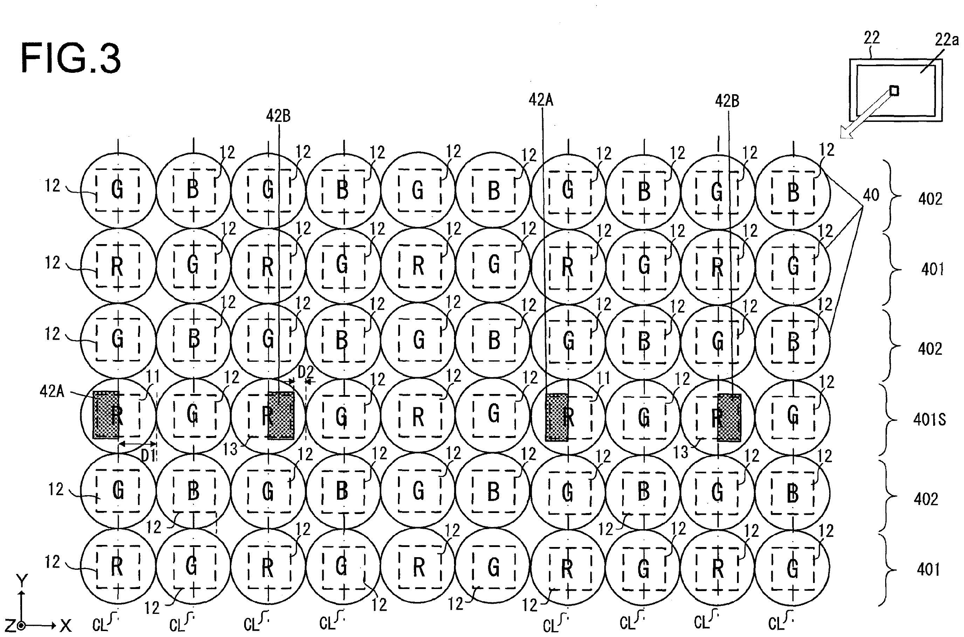

Fig. 3 is an enlarged view of a portion of an array of pixels on the image sensor 22. A plurality of pixels that include photoelectric conversion units are arranged upon the image sensor 22 in a two dimensional configuration (for example, in a row direction and a column direction) within a region 22a that generates an image. To each of the pixels is provided one of three color filters having different spectral characteristics, for example R (red), G (green), and B (blue). The R color filters principally pass light in a red color wavelength region. Moreover, the G color filters principally pass light in a green color wavelength region. And the B color filters principally pass light in a blue color wavelength region. Due to this, the various pixels have different spectral characteristics, according to the color filters with which they are provided. The G color filters pass light of a shorter wavelength region than the R color filters. And the B color filters pass light of a shorter wavelength region than the G color filters.

On the image sensor 22, pixel rows 401 in which pixels having R and G color filters (hereinafter respectively termed "R pixels" and "G pixels") are arranged alternately, and pixel rows 402 in which pixels having G and B color filters (hereinafter respectively termed "G pixels" and "B pixels") are arranged alternately, are arranged repeatedly in a two dimensional pattern. In this manner, for example, the R pixels, G pixels, and B pixels are arranged according to a Bayer array.

The image sensor 22 includes imaging pixels 12 that are R pixels, G pixels, and B pixels arrayed as described above, and focus detection pixels 11, 13 that are disposed so as to replace some of the imaging pixels 12. Among the pixel rows 401, the reference symbol 401 S is appended to the pixel rows in which focus detection pixels 11, 13 are disposed.

In Fig. 3, a case is shown by way of example in which the focus detection pixels 11, 13 are arranged along the row direction (the X axis direction), in other words along the horizontal direction. A plurality of pairs of the focus detection pixels 11, 13 are arranged repeatedly along the row direction (the X axis direction). In this embodiment, each of the focus detection pixels 11, 13 is disposed in the position of an R pixel. The focus detection pixels 11 have reflecting portions 42A, and the focus detection pixels 13 have reflecting portions 42B.

It would also be acceptable to arrange for a plurality of the pixel rows 401S shown by way of example in Fig. 3 to be disposed repeatedly along the column direction (i.e. along the Y axis direction).

It should be understood that it would be acceptable for the focus detection pixels 11, 13 to be disposed in the positions of some of R pixels; or it would also be acceptable for the focus detection pixels 11, 13 to be disposed in the positions of all R pixels. It would also be acceptable for each of the focus detection pixels 11, 13 to be disposed in the position of a G pixel.

The signals that are read out from the imaging pixels 12 of the image sensor 22 are employed as image signals by the body control unit 21. Moreover, the signals that are read out from the focus detection pixels 11, 13 of the image sensor 22 are employed as focus detection signals by the body control unit 21.

It should be understood that the signals that are read out from the focus detection pixels 11, 13 of the image sensor 22 may be also employed as image signals by being corrected.

Next, the imaging pixels 12 and the focus detection pixels 11, 13 will be explained in detail.

The Imaging Pixels

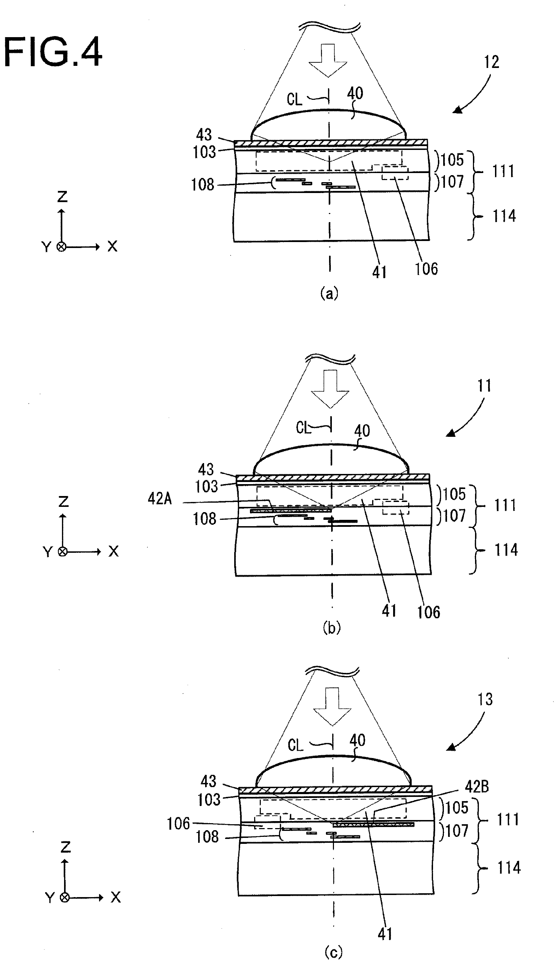

Fig. 4(a) is an enlarged sectional view of an exemplary one of the imaging pixels 12, and is a sectional view of one of the imaging pixels 12 of Fig. 3 taken in a plane parallel to the X-Z plane. The line CL is a line passing through the center of this imaging pixel 12. This image sensor 22 is, for example, of the backside illumination type, with a first substrate 111 and a second substrate 114 being laminated together therein via an adhesion layer not shown in the figures. The first substrate 111 is made as a semiconductor substrate. Moreover, the second substrate 114 is made as a semiconductor substrate or as a glass substrate or the like, and functions as a support substrate for the first substrate 111.

A color filter 43 is provided over the first substrate 111 (on its side in the +Z axis direction) via a reflection prevention layer 103. Moreover, a micro lens 40 is provided over the color filter 43 (on its side in the +Z axis direction). Light is incident upon the imaging pixel 12 in the direction shown by the white arrow sign from above the micro lens 40 (i.e. from the +Z axis direction). The micro lens 40 condenses the incident light onto a photoelectric conversion unit 41 on the first substrate 111.

In relation to the micro lens 40 of this imaging pixel 12, the optical characteristics of the micro lens 40, for example its optical power, are determined so as to cause the intermediate position in the thickness direction (i.e. in the Z axis direction) of the photoelectric conversion unit 41 and the position of the pupil of the imaging optical system 31 (i.e. an exit pupil 60 that will be explained hereinafter) to be mutually conjugate. The optical power may be adjusted by varying the curvature of the micro lens 40 or by varying its refractive index. Varying the optical power of the micro lens 40 means changing the focal length of the micro lens 40. Moreover, it would also be acceptable to arrange to adjust the focal length of the micro lens 40 by changing its shape or its material. For example, if the curvature of the micro lens 40 is reduced, then its focal length becomes longer. Moreover, if the curvature of the micro lens 40 is increased, then its focal length becomes shorter. If the micro lens 40 is made from a material whose refractive index is low, then its focal length becomes longer. Moreover, if the micro lens 40 is made from a material whose refractive index is high, then its focal length becomes shorter. If the thickness of the micro lens 40 (i.e. its dimension in the Z axis direction) becomes smaller, then its focal length becomes longer. Moreover, if the thickness of the micro lens 40 (i.e. its dimension in the Z axis direction) becomes larger, then its focal length becomes shorter. It should be understood that, when the focal length of the micro lens 40 becomes longer, then the position at which the light incident upon the photoelectric conversion unit 41 is condensed shifts in the direction to become deeper (i.e. shifts in the -Z axis direction). Moreover, when the focal length of the micro lens 40 becomes shorter, then the position at which the light incident upon the photoelectric conversion unit 41 is condensed shifts in the direction to become shallower (i.e. shifts in the +Z axis direction).

According to the structure described above, it is avoided that any part of the ray bundle that has passed through the pupil of the imaging optical system 31 is incident upon any region outside the photoelectric conversion unit 41, and leakage of the ray bundle to adjacent pixels is prevented, so that the amount of light incident upon the photoelectric conversion unit 41 is increased. To put it in another manner, the amount of electric charge generated by the photoelectric conversion unit 41 is increased.

A semiconductor layer 105 and a wiring layer 107 are laminated together in the first substrate 111. The photoelectric conversion unit 41 and an output unit 106 are provided in the first substrate 111. The photoelectric conversion unit 41 is built, for example, by a photodiode (PD), and light incident upon the photoelectric conversion unit 41 is photoelectrically converted and thereby electric charge is generated. Light that has been condensed by the micro lens 40 is incident upon the upper surface of the photoelectric conversion unit 41 (i.e. from the +Z axis direction). The output unit 106 includes a transfer transistor and an amplification transistor and so on, not shown in the figures. The output unit 106 outputs a signal generated by the photoelectric conversion unit 41 to the wiring layer 107. For example, n+ regions are formed on the semiconductor layer 105, and respectively constitute a source region and a drain region for the transfer transistor. Moreover, a gate electrode of the transfer transistor is formed on the wiring layer 107, and this electrode is connected to wiring 108 that will be described hereinafter.

The wiring layer 107 includes a conductor layer (i.e. a metallic layer) and an insulation layer, and a plurality of wires 108 and vias and contacts and so on not shown in the figure are disposed therein. For example, copper or aluminum or the like may be employed for the conductor layer. And the insulation layer may, for example, consist of an oxide layer or a nitride layer or the like. The signal of the imaging pixel 22 that has been outputted from the output unit 106 to the wiring layer 107 is, for example, subjected to signal processing such as A/D conversion and so on by peripheral circuitry not shown in the figures provided on the second substrate 114, and is read out by the body control unit 21 (refer to Fig. 1).

As shown by way of example in Fig. 3, a plurality of the imaging pixels 12 of Fig. 4(a) are arranged in the X axis direction and the Y axis direction, and these are R pixels, G pixels, and B pixels. These R pixels, G pixels, and B pixels all have the structure shown in Fig. 4(a), but with the spectral characteristics of their respective color filters 43 being different from one another.

The Focus Detection Pixels

Fig. 4(b) is an enlarged sectional view of an exemplary one of the focus detection pixels 11, and this sectional view of one of the focus detection pixels 11 of Fig. 3 is taken in a plane parallel to the X-Z plane. To structures that are similar to structures of the imaging pixel 12 of Fig. 4(a), the same reference symbols are appended, and explanation thereof will be curtailed. The line CL is a line passing through the center of this focus detection pixel 11, in other words extending along the optical axis of the micro lens 40 and through the center of the photoelectric conversion unit 41. The fact that this focus detection pixel 11 is provided with a reflecting portion 42A below the lower surface of its photoelectric conversion unit 41 (i.e. in the -Z axis direction) is a feature that is different, as compared with the imaging pixel 12 of Fig. 4(a). It should be understood that it would also be acceptable for this reflecting portion 42A to be provided as separated in the -Z axis direction from the lower surface of the photoelectric conversion unit 41. The lower surface of the photoelectric conversion unit 41 is its surface on the opposite side from its upper surface onto which the light is incident via the micro lens 40.

The reflecting portion 42A may, for example, be built as a multi-layered structure including a conductor layer made from copper, aluminum, tungsten or the like provided in the wiring layer 107, or an insulation layer made from silicon nitride or silicon oxide or the like. The reflecting portion 42A covers almost half of the lower surface of the photoelectric conversion unit 41 (on the left side of the line CL, i.e. the -X axis direction). Due to the provision of the reflecting portion 42A, at the left half of the photoelectric conversion unit 41, light that has been proceeding in the downward direction (i.e. in the -Z axis direction) in the photoelectric conversion unit 41 and has passed through the photoelectric conversion unit 41 is reflected back upward by the reflecting portion 42A, and is then again incident upon the photoelectric conversion unit 41 for a second time. Since this light that is again incident upon the photoelectric conversion unit 41 is photoelectrically converted thereby, accordingly the amount of electric charge that is generated by the photoelectric conversion unit 41 is increased, as compared to the case of an imaging pixel 12 to which no reflecting portion 42A is provided.

In relation to the micro lens 40 of this focus detection pixel 11, the optical power of the micro lens 40 is determined so that the position of the lower surface of the photoelectric conversion unit 41, in other words the position of the reflecting portion 42A, is conjugate to the position of the pupil of the imaging optical system 31 (in other words, to the exit pupil 60 that will be explained hereinafter).

Accordingly, as will be explained in detail hereinafter, along with first and second ray bundles that have passed through first and second regions of the pupil of the imaging optical system 31 being incident upon the photoelectric conversion unit 41, also, among the light that has passed through the photoelectric conversion unit 41, this second ray bundle that has passed through the second pupil region is reflected by the reflecting portion 42A, and is again incident upon the photoelectric conversion unit 41 for a second time.

Due to the provision of the structure described above, it is avoided that the first and second ray bundles should be incident upon a region outside the photoelectric conversion unit 41 or should leak to an adjacent pixel, so that the amount of light incident upon the photoelectric conversion unit 41 is increased. To put this in another manner, the amount of electric charge generated by the photoelectric conversion unit 41 is increased.

It should be understood that it would also be acceptable for a part of the wiring 108 formed in the wiring layer 107, for example a part of a signal line connected to the output unit 106, to be also employed as the reflecting portion 42A. In this case, the reflecting portion 42A would serve both as a reflective layer that reflects back light that has been proceeding in the direction downward (i.e. in the -Z axis direction) in the photoelectric conversion unit 41 and has passed through the photoelectric conversion unit 41, and also as a signal line that transmits a signal.

In a similar manner to the case with the imaging pixel 12, the signal of the focus detection pixel 11 that has been outputted from the output unit 106 to the wiring layer 107 is subjected to signal processing such as, for example, A/D conversion and so on by peripheral circuitry not shown in the figures provided on the second substrate 114, and is then read out by the body control unit 21 (refer to Fig. 1).

It should be understood that, in Fig. 4(b), it is shown that the output unit 106 of the focus detection pixel 11 is provided at a region of the focus detection pixel 11 at which the reflecting portion 42A is not present (i.e. at a region more toward the +X axis direction than the line CL). However, it would also be acceptable for the output unit 106 to be provided at a region of the focus detection pixel 11 at which the reflecting portion 42A is present (i.e. at a region more toward the -X axis direction than the line CL).

Fig. 4(c) is an enlarged sectional view of an exemplary one of the focus detection pixels 13, and is a sectional view of one of the focus detection pixels 13 of Fig. 3 taken in a plane parallel to the X-Z plane. To structures that are similar to structures of the focus detection pixel 11 of Fig. 4(b), the same reference symbols are appended, and explanation thereof will be curtailed. This focus detection pixel 13 has a reflecting portion 42B in a position that is different from that of the reflecting portion 42A of the focus detection pixel 11 of Fig. 4(b). The reflecting portion 42B covers almost half of the lower surface of the photoelectric conversion unit 41 (the portion more to the right side (i.e. toward the +X axis direction) than the line CL). Due to the provision of this reflecting portion 42B, on the right half of the photoelectric conversion unit 41, light that has been proceeding in the downward direction (i.e. in the -Z axis direction) in the photoelectric conversion unit 41 and has passed through the photoelectric conversion unit 41 is reflected back by the reflecting portion 42B, and is then again incident upon the photoelectric conversion unit 41. Since this light that is again incident upon the photoelectric conversion unit 41 is photoelectrically converted thereby, accordingly the amount of electric charge that is generated by the photoelectric conversion unit 41 is increased, as compared with the case of an imaging pixel 12 to which no reflecting portion 42B is provided.

In other words, as will be explained hereinafter in detail, in the focus detection pixel 13, along with first and second ray bundles that have passed through the first and second regions of the pupil of the imaging optical system 31 being incident upon the photoelectric conversion unit 41, among the light that passes through the photoelectric conversion unit 41, the first ray bundle that has passed through the first pupil region is reflected back by the reflecting portion 42B and is again incident upon the photoelectric conversion unit 41 for a second time.

As described above, in the focus detection pixels 11, 13, among the first and second ray bundles that have passed through the first and second regions of the pupil of the imaging optical system 31, for example, the reflecting portion 42B of the focus detection pixel 13 reflects back the first ray bundle, while, for example, the reflecting portion 42A of the focus detection pixel 11 reflects back the second ray bundle.

In the focus detection pixel 13, in relation to the micro lens 40, the optical power of the micro lens 40 is determined so that the position of the reflecting portion 42B that is provided at the lower surface of the photoelectric conversion unit 41 and the position of the pupil of the imaging optical system 31 (i.e. the position of its exit pupil 60 that will be explained hereinafter) are mutually conjugate.

By providing the structure described above, the first and second ray bundles are prevented from being incident upon regions other than the photoelectric conversion unit 41, and leakage to adjacent pixels is prevented, so that the amount of light incident upon the photoelectric conversion unit 41 is increased. To put it in another manner, the amount of electric charge generated by the photoelectric conversion unit 41 is increased.

In the focus detection pixel 13, it would also be possible to employ a part of the wiring 108 formed on the wiring layer 107, for example a part of a signal line that is connected to the output unit 106, as the reflecting portion 42B, in a similar manner to the case with the focus detection pixel 11. In this case, the reflecting portion 42B would be employed both as a reflecting layer that reflects back light that has been proceeding in a downward direction (i.e. in the -Z axis direction) in the photoelectric conversion unit 41 and has passed through the photoelectric conversion unit 41, and also as a signal line for transmitting a signal.

Moreover, in the focus detection pixel 13, it would also be acceptable to employ, as the reflecting portion 42B, a part of an insulation layer that is employed in the output unit 106. In this case, the reflecting portion 42B would be employed both as a reflecting layer that reflects back light that has been proceeding in a downward direction (i.e. in the -Z axis direction) in the photoelectric conversion unit 41 and has passed through the photoelectric conversion unit 41, and also as an insulation layer.

In a similar manner to the case with the focus detection pixel 11, the signal of the focus detection pixel 13 that is outputted from the output unit 106 to the wiring layer 107 is subjected to signal processing such as A/D conversion and so on by, for example, peripheral circuitry not shown in the figures provided to the second substrate 114, and is read out by the body control unit 21 (refer to Fig. 1).

It should be understood that, in a similar manner to the case with the focus detection pixel 11, the output unit 106 of the focus detection pixel 13 may be provided in a region in which the reflecting portion 42B is not present (i.e. in a region more to the -X axis direction than the line CL), or may be provided in a region in which the reflecting portion 42B is present (i.e. in a region more to the +X axis direction than the line CL).

In general, semiconductor substrates such as silicon substrates or the like have the characteristic that their transmittance is different according to the wavelength of the incident light. With light of longer wavelength, the transmittance through a silicon substrate is higher as compared to light of shorter wavelength. For example, among the light that is photoelectrically converted by the image sensor 22, the light of red color whose wavelength is longer passes more easily through the semiconductor layer 105 (i.e. through the photoelectric conversion unit 41), as compared to the light of other colors (i.e. of green color or blue color).

In the example of Fig. 3, the focus detection pixels 11, 13 are disposed in the positions of R pixels. Due to this, if the light proceeding in the downward direction through the photoelectric conversion units 41 (i.e. in the -Z axis direction) is red color light, then it can easily pass through the photoelectric conversion units 41 and reach the reflecting portions 42A, 42B. And, due to this, this light of red color that has passed through the photoelectric conversion units 41 can be reflected back by the reflecting portions 42A, 42B so as to be again incident upon the photoelectric conversion units 41 for a second time. As a result, the amounts of electric charge generated by the photoelectric conversion units 41 of the focus detection pixels 11, 13 are increased.

As described above, the position of the reflecting portion 42A of the focus detection pixel 11 and the position of the reflecting portion 42B of the focus detection pixel 13, with respect to the photoelectric conversion unit 41 of the focus detection pixel 11 and the photoelectric conversion unit 41 of the focus detection pixel 13 respectively, are different. Moreover, the position of the reflecting portion 42A of the focus detection pixel 11 and the position of the reflecting portion 42B of the focus detection pixel 13, with respect to the optical axis of the micro lens 40 of the focus detection pixel 11 and the optical axis of the micro lens 40 of the focus detection pixel 13 respectively, are different.

In a plane (the XY plane) that intersects the direction in which light is incident (i.e. the -Z axis direction), the reflecting portion 42A of the focus detection pixel 11 is provided in a region that is toward the -X axis side from the center of the photoelectric conversion unit 41 of the focus detection pixel 11. Furthermore, in the XY plane, among the regions subdivided by a line that is parallel to a line passing through the center of the photoelectric conversion unit 41 of the focus detection pixel 11 and extending along the Y axis direction, at least a portion of the reflecting portion 42A of the focus detection pixel 11 is provided in the region toward the -X axis side. To put it in another manner, in the XY plane, among the regions subdivided by a line that is orthogonal to the line CL in Fig. 4 and that is parallel to the Y axis, at least a portion of the reflecting portion 42A of the focus detection pixel 11 is provided in the region toward the -X axis side.

On the other hand, in a plane (the XY plane) that intersects the direction in which light is incident (i.e. the -Z axis direction), the reflecting portion 42B of the focus detection pixel 13 is provided in a region that is toward the +X axis side from the center of the photoelectric conversion unit 41 of the focus detection pixel 13. Furthermore, in the XY plane, among the regions that are subdivided by a line that is parallel to a line passing through the center of the photoelectric conversion unit 41 of the focus detection pixel 13 and extending along the Y axis direction, at least a portion of the reflecting portion 42B of the focus detection pixel 13 is provided in the region toward the +X axis side. To put it in another manner, in the XY plane, among the regions that are subdivided by a line that is orthogonal to the line CL in Fig. 4 and is parallel to the Y axis, at least a portion of the reflecting portion 42B of the focus detection pixel 13 is provided in the region toward the +X axis side.

The explanation of the relationship between the positions of the reflecting portion 42A and the reflecting portion 42B of the focus detection pixels 11, 13 and the adjacent pixels is as follows. That is, in a direction that intersects the direction in which light is incident (i.e., in the example of Fig. 3, in the X axis direction or in the Y axis direction), the respective reflecting portions 42A and 42B of the focus detection pixels 11, 13 are provided at different distances from adjacent pixels. In concrete terms, the reflecting portion 42A of the focus detection pixel 11 is provided at a first distance D1 from the adjacent imaging pixel 12 on its right in the X axis direction. And the reflecting portion 42B of the focus detection pixel 13 is provided at a second distance D2, which is different from the above first distance D1, from the adjacent imaging pixel 12 on its right in the X axis direction.

It should be understood that a case in which the first distance D1 and the second distance D2 are both substantially zero will also be acceptable. Moreover, instead of representing the positions of the reflecting portion 42A of the focus detection pixel 11 and the reflecting portion 42B of the focus detection pixel 13 in the XY plane by the distances from the side edge portions of those reflecting portions to the adjacent imaging pixels on the right, it would also be acceptable to represent them by the distances from the center positions upon those reflecting portions to some other pixels (for example, to the adjacent imaging pixels on the right).

Furthermore, it would also be acceptable to represent the positions of the focus detection pixel 11 and the focus detection pixel 13 in the XY plane by the distances from the center positions upon their reflecting portions to the center positions on the same pixels (for example, to the centers of the corresponding photoelectric conversion units 41). Yet further, it would also be acceptable to represent those positions by the distances from the center positions upon the reflecting portions to the optical axes of the micro lenses 40 of the same pixels.

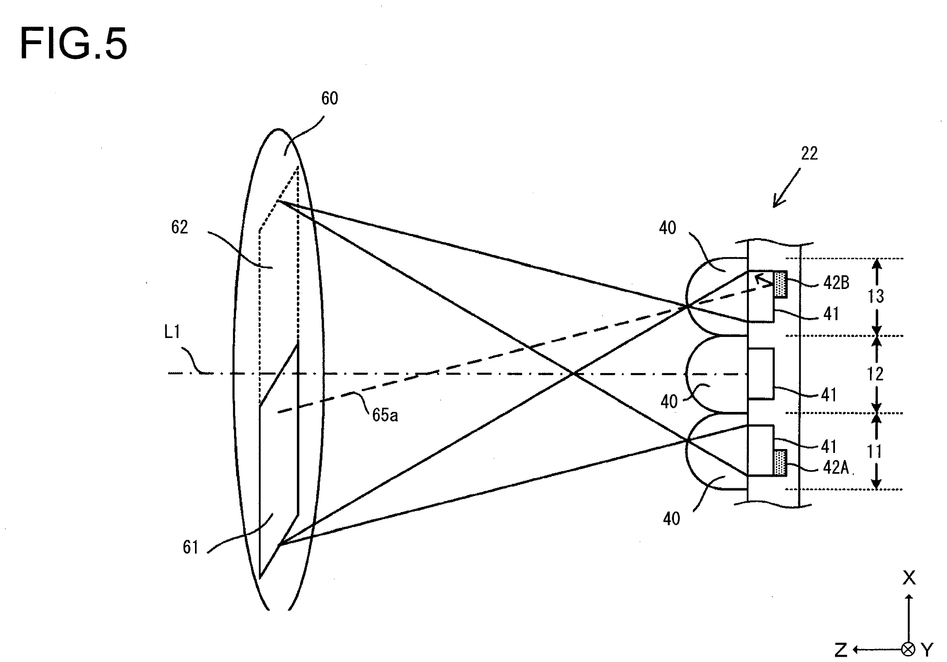

Fig. 5 is a figure for explanation of ray bundles incident upon the focus detection pixels 11, 13. The illustration shows a single unit consisting of two focus detection pixels 11, 13 and an imaging pixel 12 sandwiched between them. Directing attention to the focus detection pixel 13 of Fig. 5, a first ray bundle that has passed through a first pupil region 61 of the exit pupil 60 of the imaging optical system 31 (refer to Fig. 1) and a second ray bundle that has passed through a second pupil region 62 of that exit pupil 60 are incident upon the photoelectric conversion unit 41 via the micro lens 40. Moreover light among the first ray bundle that is incident upon the photoelectric conversion unit 41 and that has passed through the photoelectric conversion unit 41 is reflected by the reflecting portion 42B and is then again incident upon the photoelectric conversion unit 41 for a second time.

It should be understood that, in Fig. 5, light that passes through the first pupil region 61 and passes through the micro lens 40 and the photoelectric conversion unit 41 of the focus detection pixel 13, and that is then reflected back by the reflecting portion 42B and is then again incident upon the photoelectric conversion unit 41 for a second time, is schematically shown by the broken line 65a.

The signal Sig(13) obtained by the focus detection pixel 13 can be expressed by the following Equation (1):

$$Sig(13) = S1 + S2 + S1' .... (1)$$

Here, the signal S1 is a signal based upon an electrical charge resulting from photoelectric conversion of the first ray bundle that has passed through the first pupil region 61 to be incident upon the photoelectric conversion unit 41. Moreover, the signal S2 is a signal based upon an electrical charge resulting from photoelectric conversion of the second ray bundle that has passed through the second pupil region 62 to be incident upon the photoelectric conversion unit 41. And the signal S1' is a signal based upon an electrical charge resulting from photoelectric conversion of the light, among the first ray bundle that has passed through the photoelectric conversion unit 41, that has been reflected by the reflecting portion 42B and has again been incident upon the photoelectric conversion unit 41 for a second time.

Now directing attention to the focus detection pixel 11 of Fig. 5, a first ray bundle that has passed through the first pupil region 61 of the exit pupil 60 of the imaging optical system 31 (refer to Fig. 1) and a second ray bundle that has passed through the second pupil region 62 of that exit pupil 60 are incident upon the photoelectric conversion unit 41 via the micro lens 40. Moreover light among the second ray bundle that is incident upon the photoelectric conversion unit 41 and that has passed through the photoelectric conversion unit 41 is reflected by the reflecting portion 42A and is then again incident upon the photoelectric conversion unit 41 for a second time.

Moreover, the signal Sig(11) obtained by the focus detection pixel 11 can be expressed by the following Equation (2):

$$Sig(11) = S1 + S2 + S2' .... (2)$$

Here, the signal S1 is a signal based upon an electrical charge resulting from photoelectric conversion of the first ray bundle that has passed through the first pupil region 61 to be incident upon the photoelectric conversion unit 41. Moreover, the signal S2 is a signal based upon an electrical charge resulting from photoelectric conversion of the second ray bundle that has passed through the second pupil region 62 to be incident upon the photoelectric conversion unit 41. And the signal S2' is a signal based upon an electrical charge resulting from photoelectric conversion of the light, among the second ray bundle that has passed through the photoelectric conversion unit 41, that has been reflected by the reflecting portion 42A and has again been incident upon the photoelectric conversion unit 41 for a second time.

And, directing attention to the focus detection pixel 12 of Fig. 5, a first ray bundle that has passed through the first pupil region 61 of the exit pupil 60 of the imaging optical system 31 (refer to Fig. 1) and a second ray bundle that has passed through the second pupil region 62 of that exit pupil 60 are incident upon the photoelectric conversion unit 41 via the micro lens 40.

And the signal Sig(12) obtained by the imaging pixel 12 may be given by the following Equation (3):

$$Sig(12) = S1 + S2 .... (3)$$

Here, the signal S1 is a signal based upon an electrical charge resulting from photoelectric conversion of the first ray bundle that has passed through the first pupil region 61 to be incident upon the photoelectric conversion unit 41. Moreover, the signal S2 is a signal based upon an electrical charge resulting from photoelectric conversion of the second ray bundle that has passed through the second pupil region 62 to be incident upon the photoelectric conversion unit 41.

Generation of the Image Data

The image generation unit 21b of the body control unit 21 generates image data related to an image of the photographic subject on the basis of the signal Sig(12) described above from the imaging pixel 12, the signal Sig(11) described above from the focus detection pixel 11, and the signal Sig(13) described above from the focus detection pixel 13.

It should be understood that, when generating this image data, in order to suppress the influence of the signal S2' and the signal S1', or, to put it in another manner, in order to suppress differences in the amount of electric charge generated by the photoelectric conversion unit 41 of the imaging pixel 12 and the amounts of electric charge generated by the photoelectric conversion units 41 of the focus detection pixels 11, 13, it may be arranged to provide a difference between the gain applied to the signal Sig(12) from the imaging pixel 12 and the gains applied to the signal Sig(11) and to the signal Sig(13) from the focus detection pixels 11, 13 respectively. For example, it may be arranged for the gains applied to the signal Sig(11) and to the signal Sig(13) from the focus detection pixels 11, 13 respectively to be smaller, as compared to the gain applied to the signal Sig(12) from the imaging pixel 12.

Detection of the Amount of Image Deviation

The focus detection unit 21 a of the body control unit 21 detects an amount of image deviation on the basis of the signal Sig(12) from the imaging pixel 12, the signal Sig(11) from the focus detection pixel 11, and the signal Sig(13) from the focus detection pixel 13. To explain an example, the focus detection unit 21a obtains a difference diff2 between the signal Sig(12) from the imaging pixel 12 and the signal Sig(11) from the focus detection pixel 11, and also obtains a difference diff1 between the signal Sig(12) from the imaging pixel 12 and the signal Sig(13) from the focus detection pixel 13. The difference diff2 corresponds to the signal S2' based upon the electric charge that has been obtained by photoelectric conversion of the light, among the second ray bundle that has passed through the photoelectric conversion unit 41 of the focus detection pixel 11, that has been reflected by the reflecting portion 42A and is again incident upon the photoelectric conversion unit 41 for a second time. In a similar manner, the difference diff1 corresponds to the signal S1' based upon the electric charge that has been obtained by photoelectric conversion of the light, among the first ray bundle that has passed through the photoelectric conversion unit 41 of the focus detection pixel 13, that has been reflected by the reflecting portion 42B and is again incident upon the photoelectric conversion unit 41 for a second time.

It will also be acceptable to arrange for the focus detection unit 21a, when calculating the differences diff2 and diff1 described above, to subtract a value obtained by multiplying the signal Sig(12) from the imaging pixel 12 by a constant value from the signals Sig(11) and Sig(13) from the focus detection pixels 11, 13.

On the basis of these differences diff2 and diff1 that have thus been obtained, the focus detection unit 21a obtains an amount of image deviation between an image due to the first ray bundle that has passed through the first pupil region 61 (refer to Fig. 5) and an image due to the second ray bundle that has passed through the second pupil region 62 (refer to Fig. 5). In other words, by considering together and combining the group of differences diff2 of the signals obtained by the plurality of units described above, and the group of differences diff1 of the signals obtained by the plurality of units described above, the focus detection unit 21a obtains information showing the intensity distributions of the plurality of images formed by the plurality of focus detection ray bundles that have respectively passed through the first pupil region 61 and through the second pupil region 62.

By executing image deviation detection calculation processing (i.e. correlation calculation processing and phase difference detection processing) upon the intensity distributions of the plurality of images described above, the focus detection unit 21a calculates the amount of image deviation of the plurality of images. Moreover, the focus detection unit 21a calculates an amount of defocusing by multiplying this amount of image deviation by a predetermined conversion coefficient. Since image deviation detection calculation and amount of defocusing calculation according to this pupil-split type phase difference detection method are per se known, accordingly detailed explanation thereof will be curtailed.

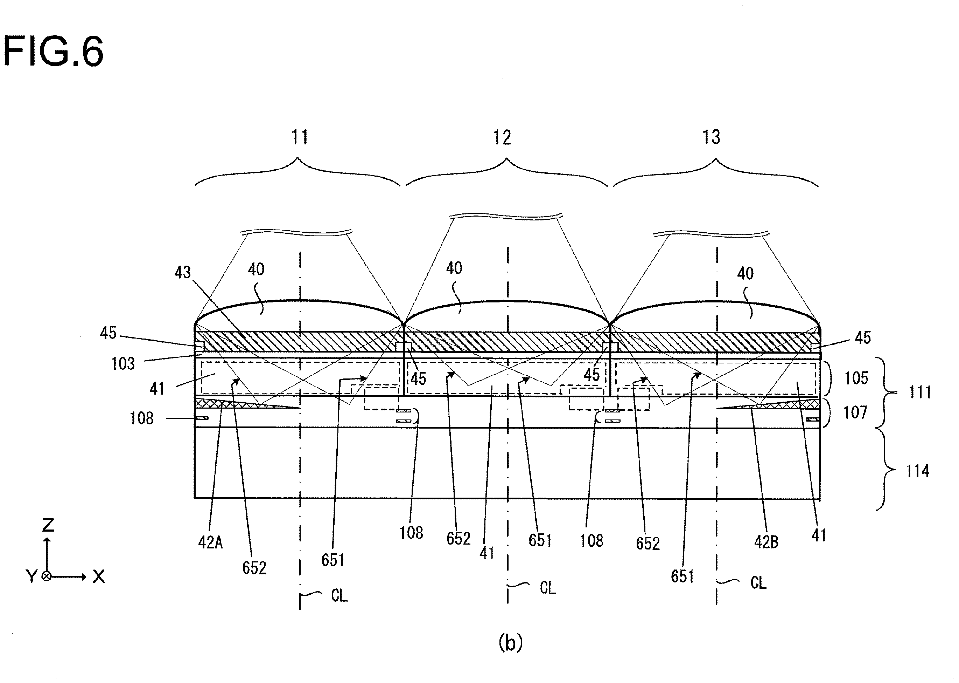

Fig. 6 is an enlarged sectional view of a single unit according to this embodiment, consisting of focus detection pixels 11, 13 and an imaging pixel 12 sandwiched between them. This sectional view is a figure in which the single unit of Fig. 3 is cut parallel to the X-Z plane. The same reference symbols are appended to structures of the imaging pixel 12 of Fig. 4(a), to structures of the focus detection pixel 11 of Fig. 4(b) and to structures of the focus detection pixel 13 of Fig. 4(c) which are the same, and explanation thereof will be curtailed. And the lines CL are lines that pass through the centers of the pixels 11, 12, and 13 (for example, through the centers of their micro lenses).

For example, light shielding layers 45 are provided between the various pixels, so as to suppress leakage of light that has passed through the micro lenses 40 of the pixels to the photoelectric conversion units 41 of adjacent pixels. It should be understood that element separation portions not shown in the figures may be provided between the photoelectric conversion units 41 of the pixels in order to separate them, so that leakage of light or electric charge within the semiconductor layer to adjacent pixels can be suppressed.

Shapes of the Reflecting Portions

The reflective surface of the reflecting portion 42A of the focus detection pixel 11 reflects back light that has passed through the photoelectric conversion unit 41 in a direction that intersects the line CL, and moreover in a direction to be again incident upon the photoelectric conversion unit 41. For this purpose, for example, the reflective surface of the reflecting portion 42A of the focus detection pixel 11 (i.e. its surface toward the +Z axis direction) is formed to be slanting with respect to the optical axis of the micro lens 40. Thus, the reflective surface of the reflecting portion 42A is formed as a sloping surface that becomes farther away from the micro lens 40 in the Z axis direction, the closer in the X axis direction to the line CL that passes through the center of the micro lens 40. Moreover, the reflective surface of the reflecting portion 42A is formed as a sloping surface that becomes closer to the micro lens 40 in the Z axis direction, the farther in the X axis direction from the line CL. Due to this, among the second ray bundle 652 that has passed through the second pupil region 62 (refer to Fig. 5), the light that passes slantingly (i.e. in an orientation that intersects a line parallel to the line CL) through the photoelectric conversion unit 41 toward the reflecting portion 42A of the focus detection pixel 11 is reflected by the reflecting portion 42A and proceeds toward the micro lens 40. To put it in another manner, the light reflected by the reflecting portion 42A proceeds toward the photoelectric conversion unit 41 in a direction to approach the line CL (i.e. in a direction to approach the center of the photoelectric conversion unit 41). As a result, the light reflected by the reflecting portion 42A of the focus detection pixel 11 is prevented from progressing toward the imaging pixel 12 (not shown in Fig. 6) that is positioned adjacent to the focus detection pixel 11 on the left (i.e. toward the -X axis direction).

The difference diff2 between the signal Sig(12) and the signal Sig(11) described above is phase difference information that is employed for phase difference detection. This phase difference information corresponds to the signal S2' obtained by photoelectric conversion of the light, among the second ray bundle 652 that has passed through the photoelectric conversion unit 41 of the focus detection pixel 11, that is reflected by the reflecting portion 42A and is again incident upon the photoelectric conversion unit 41 for a second time. If light that has been reflected by the reflecting portion 42A enters into the imaging pixel 12 (not shown in Fig. 6) that is positioned adjacent to the focus detection pixel 11 on its left (i.e. toward the -X axis direction), then the accuracy of detection by the pupil-split type phase difference detection method decreases, since the signal S2' that is obtained by the focus detection pixel 11 decreases. However in the present embodiment, since the reflective surface of the reflecting portion 42A of the focus detection pixel 11 (i.e. its surface toward the +Z axis direction) is formed so as to be slanting with respect to the optical axis of the micro lens 40, accordingly it is possible to suppress generation of reflected light from the focus detection pixel 11 toward the imaging pixel 12. Due to this, it is possible to prevent decrease of the accuracy of detection by the pupil-split type phase difference detection method.

In a similar manner, the reflective surface of the reflecting portion 42B of the focus detection pixel 13 reflects back light that has passed through the photoelectric conversion unit 41 in a direction that intersects the line CL, and moreover in a direction to be again incident upon the photoelectric conversion unit 41. For this purpose, for example, the reflective surface of the reflecting portion 42B of the focus detection pixel 13 (i.e. its surface toward the +Z axis direction) is also formed to be slanting with respect to the optical axis of the micro lens 40. The reflective surface of the reflecting portion 42B is formed as a sloping surface that becomes farther away from the micro lens 40 in the Z axis direction, the closer in the X axis direction to the line CL that passes through the center of the micro lens 40. Moreover, the reflective surface of the reflecting portion 42B is formed as a sloping surface that becomes closer to the micro lens 40 in the Z axis direction, the farther from the line CL. Due to this, among the first ray bundle 651 that has passed through the first pupil region 61 (refer to Fig. 5), the light that passes slantingly (i.e. in an orientation that intersects a line parallel to the line CL) through the photoelectric conversion unit 41 toward the reflecting portion 42B of the focus detection pixel 13 is reflected by the reflecting portion 42B and proceeds toward the micro lens 40. To put it in another manner, the light reflected by the reflecting portion 42B proceeds in a direction to approach a line parallel to the line CL. As a result, the light reflected by the reflecting portion 42B of the focus detection pixel 13 is prevented from progressing toward the imaging pixel 12 (not shown in Fig. 6) that is positioned adjacent to the focus detection pixel 13 on the right (i.e. toward the +X axis direction).

The difference diff1 between the signal Sig(12) and the signal Sig(13) described above is phase difference information that is employed for phase difference detection. This phase difference information corresponds to the signal S1' obtained by photoelectric conversion of the light, among the first ray bundle 651 that has passed through the photoelectric conversion unit 41 of the focus detection pixel 13, that is reflected by the reflecting portion 42B and is again incident upon the photoelectric conversion unit 41 for a second time. If light that has been reflected by the reflecting portion 42B enters into the imaging pixel 12 (not shown in Fig. 6) that is positioned adjacent to the focus detection pixel 11 on its right (i.e. toward the +X axis direction), then the accuracy of detection by the pupil-split type phase difference detection method decreases, since the signal S1' that is obtained by the focus detection pixel 13 decreases. However in the present embodiment, since the reflective surface of the reflecting portion 42B of the focus detection pixel 13 (i.e. its surface toward the +Z axis direction) is formed so as to be slanting with respect to the optical axis of the micro lens 40, accordingly it is possible to suppress generation of reflected light from the focus detection pixel 13 toward the imaging pixel 12. Due to this, it is possible to prevent decrease of the accuracy of detection by pupil-split type phase difference detection method.

According to the first embodiment described above, the following operations and beneficial effects are obtained.

(1) The image sensor 22 (refer to Fig. 6) comprises the plurality of focus detection pixels 11 (13) each of which includes a photoelectric conversion unit 41 that photoelectrically converts incident light and generates electric charge, and a reflecting portion 42A (42B) that reflects back light that has passed through the photoelectric conversion unit 41 back to the photoelectric conversion unit 41, and the reflecting portions 42A (42B) reflect light in orientations to proceed toward the vicinities of the centers of the photoelectric conversion units 41 of their pixels. Due to this, it is possible to suppress reduction of optical crosstalk in which reflected light leaks from the focus detection pixels 11 (13) to the imaging pixels 12.

(2) To explain the focus detection pixel 11 of Fig. 6 as an example, the reflective surface of the reflecting portion 42A (i.e. its surface in the +Z axis direction) is defined by a plane that is formed to be slanting with respect to the optical axis of the micro lens 40. In concrete terms, the reflective surface of the reflecting portion 42A is formed as a sloping surface that is farther away from the micro lens 40 in the Z axis direction, the closer to the line CL that passes through the center of the micro lens 40 in the X axis direction. Furthermore, the reflective surface of the reflecting portion 42A is formed as a sloping surface that is closer to the micro lens 40 in the Z axis direction, the farther from the line CL in the X axis direction. Due to this, light, among the second ray bundle 652 that has passed through the second pupil region 62 (refer to Fig. 5), that has passed slantingly through the photoelectric conversion unit 41 (i.e. in an orientation that intersects a line parallel to the line CL) toward the reflecting portion 42A of the focus detection pixel 11 is reflected by the reflecting portion 42A, and proceeds toward the micro lens 40 to be incident back for a second time upon the photoelectric conversion unit 41. To put it in another manner, the light that has been reflected by the reflecting portion 42A proceeds toward the photoelectric conversion unit 41 in an orientation to approach a line parallel to the line CL. Due to this, it is possible to suppress reduction of optical crosstalk in which reflected light leaks from the focus detection pixel 11 to an imaging pixel 12.

The same as above is also the case for the focus detection pixel 13.

Embodiment Two

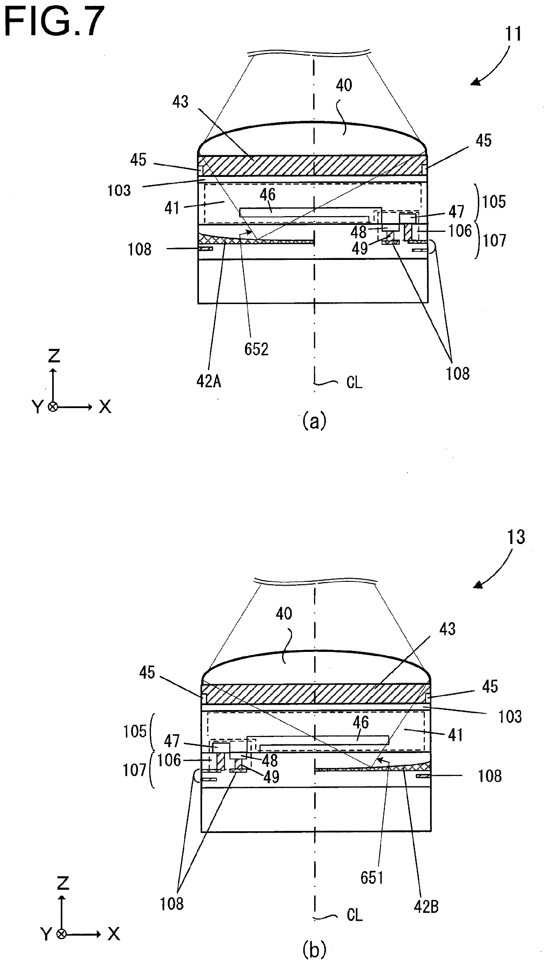

In the first embodiment, in order to prevent light reflected in the focus detection pixels 11, 13 from progressing toward an imaging pixel 12 that is positioned adjacent to the focus detection pixels 11, 13, the reflective surfaces of the reflecting portions 42A (42B) of the focus detection pixels 11 (13) (i.e. their surfaces toward the +Z axis direction) are formed as sloping surfaces that are inclined with respect to their micro lenses 40. However, with reference to Fig. 7, another example will now be explained of, in a second embodiment, light reflected in the focus detection pixels 11, 13 being prevented from progressing toward an imaging pixel 12 that is positioned adjacent to the focus detection pixels 11, 13.

Fig. 7(a) is an enlarged sectional view of a focus detection pixel 11 according to the second embodiment. Moreover, Fig. 7(b) is an enlarged sectional view of a focus detection pixel 13 according to the second embodiment. Both these sectional views are figures that are cut parallel to the X-Z plane. To structures that are the same as ones of the focus detection pixel 11 and the focus detection pixel 13 according to the first embodiment shown in Fig. 6, the same reference symbols are appended, and explanation thereof will be curtailed.

An n+ region 46 and an n+ region 47 are formed in the semiconductor layer 105 with the use of an N type impurity, although this feature is not shown in Fig. 6. This n+ region 46 and this n+ region 47 function as a source region and a drain region of a transfer transistor in the output unit 106. Furthermore, an electrode 48 is formed in the wiring layer 107 via an insulation layer, and functions as a gate electrode (i.e. as a transfer gate) for the transfer transistor.

The n+ region 46 also functions as part of a photodiode. The gate electrode 48 is connected via a contact 49 to a wiring portion 108 provided in the wiring layer 107. According to requirements, the wiring portions 108 of the focus detection pixel 11, the imaging pixel 12, and the focus detection pixel 13 may be mutually connected together.

The photodiode of the photoelectric conversion unit 41 generates an electric charge corresponding to the light incident thereupon. This electric charge that has thus been generated is transferred via the transfer transistor described above to the n+ region 47, which serves as a FD (floating diffusion) region. This FD region receives the electric charge and transforms it into a voltage. A signal corresponding to the electrical potential of the FD region is amplified by an amplification transistor in the output unit 106. And then this amplified signal is read out (outputted) via the wiring 108.

Shapes of the Reflecting Portions

In this second embodiment, both the reflective surface of the reflecting portion 42A of the focus detection pixel 11 (i.e. its surface toward the +Z axis direction) and also the reflective surface of the reflecting portion 42B of the focus detection pixel 13 (i.e. its surface toward the +Z axis direction) are formed as curved surfaces.

For example, the reflective surface of the reflecting portion 42A in Fig. 7(a) is formed as a curved surface that becomes farther in the Z axis direction from the micro lens 40, the closer in the X axis direction to the line CL that passes through the center of the micro lens 40. Moreover, this reflective surface of the reflecting portion 42A is formed as a curved surface that becomes closer in the Z axis direction to the micro lens 40, the farther from the line CL. Due to this, among the second ray bundle 652 that has passed through the second pupil region 62 (refer to Fig. 5), the light that has passed slantingly through the photoelectric conversion unit 41 toward the reflecting portion 42A of the focus detection pixel 11 (i.e. in an orientation that intersects a line parallel to the line CL) is reflected by the reflecting portion 42A and proceeds toward the micro lens 40. To put it in another manner, the light that has been reflected by the reflecting portion 42A proceeds in an orientation that becomes closer to a line parallel to the line CL. As a result, the light reflected by the reflecting portion 42A of the focus detection pixel 11 is prevented from proceeding toward the imaging pixel 12 (not shown in Fig. 7(a)) that is positioned on the left of and adjacent to the focus detection pixel 11 (i.e. toward the -X axis direction). In this manner, it is possible to prevent deterioration of the detection accuracy of the pupil-split type phase difference detection method.

In a similar manner, for example, the reflective surface of the reflecting portion 42B in Fig. 7(b) is formed as a curved surface that becomes farther in the Z axis direction from the micro lens 40, the closer in the X axis direction to the line CL that passes through the center of the micro lens 40. Moreover, this reflective surface of the reflecting portion 42B is formed as a curved surface that becomes closer in the Z axis direction to the micro lens 40, the farther from the line CL in the X axis direction. Due to this, among the first ray bundle 651 that has passed through the first pupil region 61 (refer to Fig. 5), the light that has passed slantingly through the photoelectric conversion unit 41 toward the reflecting portion 42B of the focus detection pixel 13 (i.e. in an orientation that intersects a line parallel to the line CL) is reflected by the reflecting portion 42B and proceeds toward the micro lens 40. To put it in another manner, the light that has been reflected by the reflecting portion 42B proceeds in an orientation that becomes closer to a line parallel to the line CL. As a result, the light reflected by the reflecting portion 42B of the focus detection pixel 13 is prevented from proceeding toward the imaging pixel 12 (not shown in Fig. 7(b)) that is positioned on the right of and adjacent to the focus detection pixel 13 (i.e. toward the +X axis direction). In this manner, it is possible to prevent deterioration of the detection accuracy of the pupil-split type phase difference detection method.

According to the second embodiment described above, the following operations and beneficial effects are obtained.

(1) The image sensor 22 (refer to Fig. 7) comprises the plurality of focus detection pixels 11 (13) each of which includes a photoelectric conversion unit 41 that photoelectrically converts incident light and generates electric charge, and a reflecting portion 42A (42B) that reflects light that has passed through the photoelectric conversion unit 41 back to the photoelectric conversion unit 41, and the reflecting portions 42A (42B) reflect light in orientations to proceed toward the photoelectric conversion units 41 of their pixels. Due to this, it is possible to suppress reduction of optical crosstalk in which reflected light leaks from the focus detection pixels 11 (13) to the imaging pixels 12.

(2) To explain the focus detection pixel 11 of Fig. 7(a) as an example, the reflective surface of the reflecting portion 42A is defined by a curved surface that is farther away from the micro lens 40 in the Z axis direction, the closer to the line CL that passes through the center of the micro lens 40 in the X axis direction. Furthermore, the reflective surface of the reflecting portion 42A is defined by a curved surface that becomes closer to the micro lens 40, the farther from the line CL in the X axis direction. Due to this, light, among the second ray bundle 652 that has passed through the second pupil region 62 (refer to Fig. 5), that has passed slantingly through the photoelectric conversion unit 41 (i.e. in an orientation that intersects a line parallel to the line CL) toward the reflecting portion 42A of the focus detection pixel 11 is reflected by the reflecting portion 42A, and proceeds back toward the micro lens 40 to be incident for a second time upon the photoelectric conversion unit 41. To put it in another manner, the light that has been reflected by the reflecting portion 42A proceeds in an orientation to approach a line parallel to the line CL. Due to this, it is possible to suppress reduction of optical crosstalk in which reflected light leaks from the focus detection pixel 11 to an imaging pixel 12.

The same as above is also the case for the focus detection pixel 13.

Variant Embodiment 1 of Embodiment Two

Shapes of the Reflecting Portions

In the second embodiment described above, the shape of the reflective surface of the reflecting portion 42A of the focus detection pixel 11 (i.e. the shape of its surface toward the +Z axis direction) and the shape of the reflective surface of the reflecting portion 42B of the focus detection pixel 13 (i.e. the shape of its surface toward the +Z axis direction) were both made to be uniform along the Y axis direction. Due to this, when the focus detection pixels 11, 13 were sectioned parallel to the X-Z plane, the cross sectional shapes of the reflecting portion 42A and of the reflecting portion 42B were the same even if the positions where they are cut were different.

Instead of this, in a first variant embodiment of the second embodiment, each of the shape of the reflective surface of the reflecting portion 42A of the focus detection pixel 11 (i.e. the shape of its surface toward the +Z axis direction) and the shape of the reflective surface of the reflecting portion 42B of the focus detection pixel 13 (i.e. the shape of its surface toward the +Z axis direction) is formed as a curved surface that varies in both the X axis direction and in the Y axis direction according to the distance from the line CL that passes through the center of the micro lens 40. To explain with an example, these surfaces may be shaped like halves of concave mirrors.

Due to this, the light, among the second ray bundle 652 that has passed through the second pupil region 62 (refer to Fig. 5), that has passed slantingly through the photoelectric conversion unit 41 toward the reflecting portion 42A of the focus detection pixel 11 (i.e. in an orientation that intersects a line parallel to the line CL) is reflected by the reflecting portion 42A, and proceeds toward the micro lens 40 to be again incident upon the photoelectric conversion unit 41 for a second time. To put it in another manner, the light reflected by the reflecting portion 42A proceeds in an orientation that becomes closer to a line parallel to the line CL. As a result, light reflected by the reflecting portion 42A of the focus detection pixel 11 is prevented from progressing toward the imaging pixel 12 that is positioned adjacent to the focus detection pixel 11 on its left (i.e. toward the -X axis direction), and also light reflected by the reflecting portion 42A of the focus detection pixel 11 is prevented from progressing toward the imaging pixels 12 that are positioned adjacent to the focus detection pixel 11 on both its sides (i.e. toward the +Y axis direction and toward the -Y axis direction). In this manner, it is possible to prevent deterioration of the detection accuracy of the pupil-split type phase difference detection method.

In a similar manner, the light, among the first ray bundle 651 that has passed through the first pupil region 61 (refer to Fig. 5), that has passed slantingly through the photoelectric conversion unit 41 toward the reflecting portion 42B of the focus detection pixel 13 (i.e. in an orientation that intersects a line parallel to the line CL) is reflected by the reflecting portion 42B, and proceeds toward the micro lens 40. To put it in another manner, the light reflected by the reflecting portion 42B proceeds in an orientation that becomes closer to a line parallel to the line CL. As a result, light reflected by the reflecting portion 42B of the focus detection pixel 13 is prevented from progressing toward the imaging pixel 12 that is positioned adjacent to the focus detection pixel 13 on its right (i.e. toward the +X axis direction), and also light reflected by the reflecting portion 42B of the focus detection pixel 13 is prevented from progressing toward the imaging pixels 12 that are positioned adjacent to the focus detection pixel 13 on both its sides (i.e. toward the +Y axis direction and toward the -Y axis direction). In this manner, it is possible to prevent deterioration of the detection accuracy of the pupil-split type phase difference detection method.

Embodiment Three

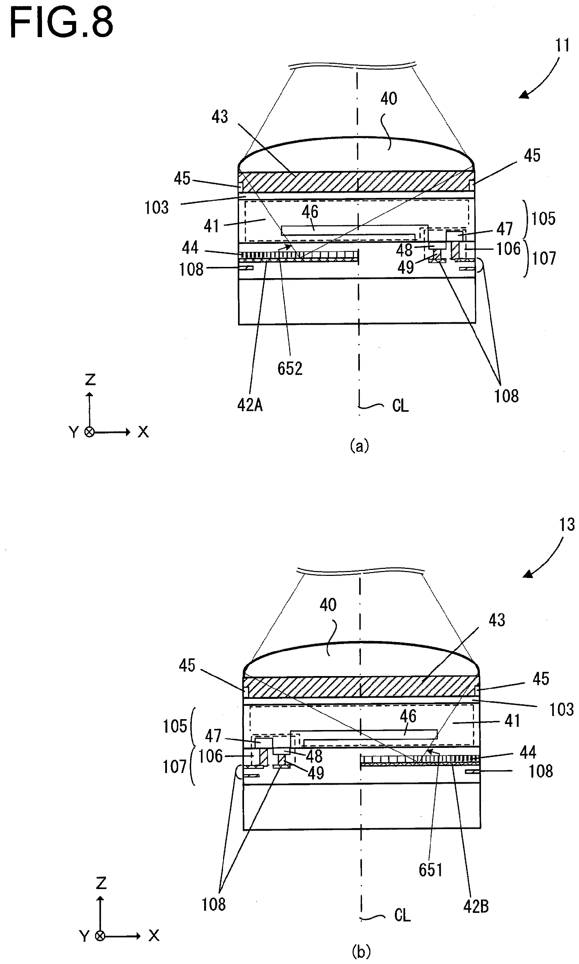

Another example of how, in a third embodiment, light reflected in the focus detection pixels 11, 13 is prevented from leaking toward the imaging pixels 12 that are positioned adjacent to the focus detection pixels 11, 13 will be explained with reference to Fig. 8.

Structure of the reflecting portions

Fig. 8(a) is an enlarged sectional view of a focus detection pixel 11 according to this third embodiment. Moreover, Fig. 8(b) is an enlarged sectional view of a focus detection pixel 13 according to the third embodiment. Both of these sectional views are figures that are cut parallel to the X-Z plane. To structures that are the same as ones of the focus detection pixel 11 shown in Fig. 7(a) and the focus detection pixel 13 shown in Fig. 7(b) according to the second embodiment, the same reference symbols are appended, and explanation thereof will be curtailed.

In this third embodiment, a gradient-index lens 44 is provided at the reflective surface side (i.e. the side in the +Z axis direction) of the reflecting portion 42A of the focus detection pixel 11. This gradient-index lens 44 is formed with a difference in refractive index, with the refractive index becoming greater in the X direction toward the line CL that passes through the center of the micro lens 40, and becoming lower in the X direction away from the line CL. Due to this, light, among the second ray bundle 652 that has passed through the second pupil region 62 (refer to Fig. 5), that has passed slantingly through the photoelectric conversion unit 41 toward the reflecting portion 42A of the focus detection pixel 11 (i.e. in an orientation that intersects a line parallel to the line CL) is reflected by the reflecting portion 42A via the gradient-index lens 44. This reflected light that has been reflected by the reflecting portion 42A proceeds toward the micro lens 40 via the gradient-index lens 44. Since, as a result, the light reflected by the reflecting portion 42A of the focus detection pixel 11 proceeds in an orientation to approach a line parallel to the line CL, accordingly it is possible to prevent this light from proceeding to the imaging pixel 12 (not shown in Fig. 8(a)) that is positioned adjacent to the focus detection pixel 11 on its left (i.e. toward the -X axis direction). In this manner, it is possible to prevent deterioration of the detection accuracy of the pupil-split type phase difference detection method.

In a similar manner, a gradient-index lens 44 is also provided at the reflective surface side (i.e. the side in the +Z axis direction) of the reflecting portion 42B of the focus detection pixel 13. Due to this, light, among the first ray bundle 651 that has passed through the first pupil region 61 (refer to Fig. 5), that has passed slantingly through the photoelectric conversion unit 41 toward the reflecting portion 42B of the focus detection pixel 13 (i.e. in an orientation that intersects a line parallel to the line CL) is reflected by the reflecting portion 42B via the gradient-index lens 44. This reflected light that has been reflected by the reflecting portion 42B proceeds toward the micro lens 40 via the gradient-index lens 44. Since, as a result, the light reflected by the reflecting portion 42B of the focus detection pixel 13 proceeds in an orientation to approach a line parallel to the line CL, accordingly it is possible to prevent this light from proceeding to the imaging pixel 12 (not shown in Fig. 8(b)) that is positioned adjacent to the focus detection pixel 13 on its right (i.e. toward the +X axis direction). In this manner, it is possible to prevent deterioration of the detection accuracy of the pupil-split type phase difference detection method.

According to the third embodiment described above, the following operations and beneficial effects are obtained.

(1) The image sensor 22 (refer to Fig. 8) comprises the plurality of focus detection pixels 11 (13) each of which includes a photoelectric conversion unit 41 that photoelectrically converts incident light and generates electric charge, and a reflecting portion 42A (42B) that reflects light that has passed through the photoelectric conversion unit 41 back to the photoelectric conversion unit 41, and the reflecting portions 42A (42B) reflect light in orientations to proceed toward the photoelectric conversion units 41 of their pixels. Due to this, it is possible to suppress reduction of optical crosstalk in which reflected light leaks from the focus detection pixels 11 (13) to the imaging pixels 12.

(2) To explain the focus detection pixel 11 of Fig. 8(a) as an example, the gradient-index lens 44 is provided upon the reflective surface side of the reflecting portion 42A of the focus detection pixel 11 (i.e. on its side in the +Z axis direction). This gradient-index lens 44 is provided with a refractive index difference, such that its refractive index becomes higher the closer in the X axis direction to the line CL that passes through the center of the micro lens 40, and its refractive index becomes lower the farther in the X axis direction from the line CL. Due to this, light, among the second ray bundle 652 that has passed through the second pupil region 62 (refer to Fig. 5), that has passed slantingly through the photoelectric conversion unit 41 (i.e. in an orientation that intersects a line parallel to the line CL) toward the reflecting portion 42A of the focus detection pixel 11 is reflected by the reflecting portion 42A via the gradient-index lens 44. This light reflected by the reflecting portion 42A proceeds via the gradient-index lens 44 toward the micro lens 40, to be incident back for a second time upon the photoelectric conversion unit 41. Due to the provision of the gradient-index lens 44, the light reflected by the reflecting portion 42A of the focus detection pixel 11 proceeds in an orientation that becomes closer to a line parallel to the line CL. Due to this, it is possible to suppress reduction of optical crosstalk in which reflected light leaks from the focus detection pixel 11 to an imaging pixel 12.

The same as above is also the case for the focus detection pixel 13.

Embodiment Four

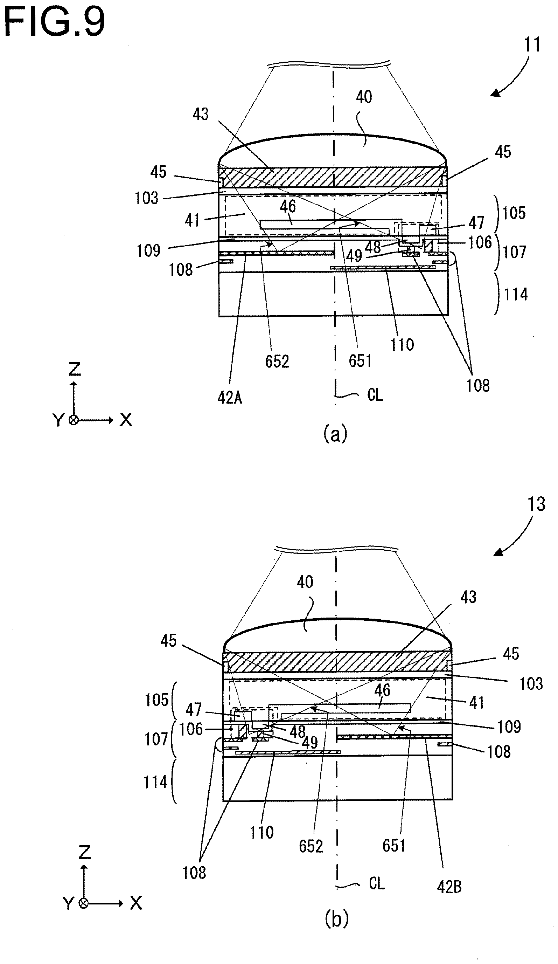

In the above explanation, an example was described in which, as a measure for suppressing reduction of the signal S2' obtained by the focus detection pixel 11 and reduction of the signal S1' obtained by the focus detection pixel 13, generation of reflected light proceeding from the focus detection pixel 11 toward the imaging pixel 12 and generation of reflected light from the focus detection pixel 13 toward the imaging pixel 12 are suppressed. However, in a fourth embodiment of the present invention, with reference to Fig. 9, another example will be explained in which reduction of the signal S2' and the signal S1' described above is suppressed.

Fig. 9(a) is an enlarged sectional view of a focus detection pixel 11 according to this fourth embodiment. Moreover, Fig. 9(b) is an enlarged sectional view of a focus detection pixel 13 according to the fourth embodiment. Both these sectional views are figures in which the focus detection pixels 11, 13 are cut parallel to the X-Z plane. To structures that are the same as ones of the focus detection pixel 11 and the focus detection pixel 13 according to the first embodiment shown in Fig. 6, the same reference symbols are appended, and explanation thereof will be curtailed. The lines CL are lines that pass through the centers of the focus detection pixels 11, 13 (for example, through the centers of their micro lenses 40).

Reflection Prevention

In this fourth embodiment, a reflection prevention layer 109 is provided between the semiconductor layer 105 and the wiring layer 107. This reflection prevention layer 109 is a layer whose optical reflectivity is low. To put it in another manner, it is a layer whose optical transmittance is high. For example, the reflection prevention layer 109 may be made as a multi-layered film in which a silicon nitride layer and a silicon oxide layer or the like are laminated together. Due to the provision of this reflection prevention layer 109, when light that has passed through the photoelectric conversion unit 41 of the semiconductor layer 105 is incident upon the wiring layer 107, it is possible to suppress the occurrence of light reflection between the photoelectric conversion unit 41 and the wiring layer 107. Moreover, due to the provision of the reflection prevention layer 109, it is also possible to suppress the occurrence of light reflection between the photoelectric conversion unit 41 and the wiring layer 107 when light reflected by the wiring layer 107 is again incident from the wiring layer 109 upon the photoelectric conversion unit 41.

For example suppose that, when no reflection prevention layer 109 is provided, 4% of the incident light is reflected when light is incident from the semiconductor layer 105 upon the wiring layer 107. Moreover suppose that, when no reflection prevention layer 109 is provided, 4% of the incident light is reflected when light is incident back from the wiring layer 107 upon the semiconductor layer 105. Accordingly, in a state in which no reflection prevention layer 109 is provided, around 8% (4%+96%×0.04=7.84%) of the light incident upon the focus detection pixel 11 is reflected, with 4% of the light that has passed through the photoelectric conversion unit 41 of the semiconductor layer 105 being reflected when it is incident upon the wiring layer 107, and another 4% being reflected when it is again incident back from the wiring layer 107 upon the photoelectric conversion unit 41 of the semiconductor layer 105. This reflected light constitutes a loss of the light incident upon the focus detection pixel 11. On the other hand, by the provision of the reflection prevention layer 109, it may be supposed that the amount of light reflection generated when light is incident from the semiconductor layer 105 upon the wiring layer 107, or when light is incident from the wiring layer 107 upon the semiconductor layer 105, may be suppressed to 1%. Accordingly, in the state in which the reflection prevention layer 109 is provided, around 2% (1%+99%× 1%=1.99%) of the light incident upon the focus detection pixel 11 is reflected. Therefore, by the provision of the reflection prevention layer 109, it is possible to suppress loss of the light incident upon the focus detection pixel 11, as compared with the case in which no reflection prevention layer 109 is provided.

Directing attention to the focus detection pixel 11, due to the provision of the reflection prevention layer 109, along with it being made easier for light to pass through from the photoelectric conversion unit 41 to the wiring layer 107, also it is made easier for light reflected by the reflecting portion 42A of the wiring layer 107 to be incident back from the wiring layer 107 upon the photoelectric conversion unit 41. In the phase difference detection method, the signal S2' obtained by the focus detection pixel 11 is required. This signal S2' is a signal based upon the light, among the second ray bundle 652 that has passed through the second pupil region 62 (refer to Fig. 5), that has been reflected by the reflecting portion 42A and is again incident back upon the photoelectric conversion unit 41. If the transmission of light from the photoelectric conversion unit 41 through to the wiring layer 107 is hampered (i.e. if reflection of light occurs and the optical transmittance between the photoelectric conversion unit 41 and the wiring layer 107 is reduced), then the signal S2' obtained from the focus detection pixel 11 is decreased. Due to this, the accuracy of detection by the pupil-split type phase difference detection method is reduced. However, with the present embodiment, due to the provision of the reflection prevention layer 109 between the semiconductor layer 105 and the wiring layer 107, it is possible to suppress reflection occurring when light that has passed through the photoelectric conversion unit 41 is reflected by the reflecting portion 42A of the wiring layer 107 and is again incident back upon the photoelectric conversion unit 41. Accordingly, it is possible to prevent reduction of the signal S2' described above due to reflection of light occurring between the semiconductor layer 105 and the wiring layer 107. In this manner, it is possible to prevent deterioration of the accuracy of detection by the pupil-split type phase difference detection method. To put it in another manner, the reflection prevention layer 109 that is provided between the semiconductor layer 105 and the wiring layer 107 is also a layer whose optical transmittance is high.

Furthermore, in the phase difference detection method, no signal based upon the first ray bundle 651 that has been obtained by the focus detection pixel 11 and has passed through the first pupil region 61 (refer to Fig. 5) is required. If the transmission of light from the photoelectric conversion unit 41 through to the wiring layer 107 is hampered (i.e. if reflection of light occurs and the optical transmittance between the photoelectric conversion unit 41 and the wiring layer 107 is reduced), then some of the light among the first ray bundle 651 to be transmitted through the photoelectric conversion unit 41, when incident from the semiconductor layer 105 upon the wiring layer 107, is reflected back to the photoelectric conversion unit 41. When this reflected light is photoelectrically converted by the photoelectric conversion unit 41, it constitutes noise for the phase difference detection method. However, in the present embodiment, due to the provision of the reflection prevention layer 109 between the semiconductor layer 105 and the wiring layer 107, it is possible to suppress the occurrence of reflection when the light that has passed through the first pupil region 61 is incident from the photoelectric conversion unit 41 upon the wiring layer 107. Accordingly it is possible to suppress the occurrence of noise due to light reflection, and it is possible to prevent deterioration of the detection accuracy of the pupil-split type phase difference detection method.

Phase difference detection is performed by employing, among the light incident upon the focus detection pixel 11, the light of longer wavelength. Due to this, among the light incident upon the focus detection pixel 11, the light of shorter wavelength constitutes a cause of noise for phase difference detection. Thus it is possible to reduce noise by providing the reflection prevention layer 109 at the portion where the reflecting portion 42A is not present, since it is thereby possible to prevent reflection of light of shorter wavelength incident upon the focus detection pixel 11.

In a similar manner, directing attention to the focus detection pixel 13, due to the provision of the reflection prevention layer 109, along with it being made easier for light to pass through from the photoelectric conversion unit 41 to the wiring layer 107, also it is made easier for light reflected by the reflecting portion 42B of the wiring layer 107 to be incident back from the wiring layer 107 upon the photoelectric conversion unit 41. In the phase difference detection method, the signal S1' obtained by the focus detection pixel 13 is required. This signal S1' is a signal based upon the light, among the first ray bundle 651 that has passed through the second pupil region 61 (refer to Fig. 5), that has been reflected by the reflecting portion 42B and is again incident back upon the photoelectric conversion unit 41. If the transmission of light from the photoelectric conversion unit 41 through to the wiring layer 107 is hampered (i.e. if reflection of light occurs and the optical transmittance between the photoelectric conversion unit 41 and the wiring layer 107 is reduced), then the signal S1' obtained from the focus detection pixel 13 is decreased. Due to this, the accuracy of detection by the pupil-split type phase difference detection method is reduced. However, with the present embodiment, due to the provision of the reflection prevention layer 109 between the semiconductor layer 105 and the wiring layer 107, it is possible to suppress reflection occurring when light that has passed through the photoelectric conversion unit 41 is reflected by the reflecting portion 42B of the wiring layer 107 and is again incident back upon the photoelectric conversion unit 41. Accordingly, it is possible to prevent reduction of the signal S1' described above due to reflection of light occurring between the semiconductor layer 105 and the wiring layer 107. In this manner, it is possible to prevent deterioration of the accuracy of detection by the pupil-split type phase difference detection method. To put it in another manner, the reflection prevention layer 109 that is provided between the semiconductor layer 105 and the wiring layer 107 is also a layer whose optical transmittance is high.

Furthermore, in the phase difference detection method, no signal based upon the second ray bundle 652 that has been obtained by the focus detection pixel 13 and has passed through the second pupil region 62 (refer to Fig. 5) is required. If the transmission of light from the photoelectric conversion unit 41 through to the wiring layer 107 is hampered (i.e. if reflection of light occurs and the optical transmittance between the photoelectric conversion unit 41 and the wiring layer 107 is reduced), then some of the light among the second ray bundle 652 to be transmitted through the photoelectric conversion unit 41, when incident from the semiconductor layer 105 upon the wiring layer 107, is reflected back to the photoelectric conversion unit 41. When this reflected light is photoelectrically converted by the photoelectric conversion unit 41, it constitutes noise for the phase difference detection method. However, in the present embodiment, due to the provision of the reflection prevention layer 109 between the semiconductor layer 105 and the wiring layer 107, it is possible to suppress the occurrence of reflection when the light that has passed through the first pupil region 61 is incident from the photoelectric conversion unit 41 upon the wiring layer 107. Accordingly it is possible to suppress the occurrence of noise due to light reflection, and it is possible to prevent deterioration of the detection accuracy of the pupil-split type phase difference detection method.

Phase difference detection is performed by employing, among the light incident upon the focus detection pixel 13, the light of longer wavelength. Due to this, among the light incident upon the focus detection pixel 13, the light of shorter wavelength constitutes a cause of noise for phase difference detection. Thus it is possible to reduce noise by providing the reflection prevention layer 109 at the portion where the reflecting portion 42B is not present, since it is thereby possible to prevent reflection of light of shorter wavelength incident upon the focus detection pixel 13.

It should be understood that, in Fig. 9(a) and Fig. 9(b), absorbing portions 110 are provided within the wiring layers 107 in order to prevent light from being transmitted through from the wiring layers 107 to the second substrates 114. For example, the first ray bundle that has passed through the first pupil region 61 of the exit pupil 60 (refer to Fig. 5) is not required by the focus detection pixel 11 for phase difference detection. The first ray bundle that has passed through from the semiconductor layer 105 (i.e. from the photoelectric conversion unit 41) to the wiring layer 107 proceeds toward the second substrate 114 through the wiring layer 107. If light is incident from the wiring layer 107 upon the second substrate 114 just as it is, then there is a possibility that noise will be generated by this light being incident upon circuitry not shown in the figures provided on the second substrate 114. However, due to the provision of the absorbing portion 110 within the wiring layer 107, the light that has passed from the semiconductor layer 105 (i.e. from the photoelectric conversion unit 41) to the wiring layer 107 is absorbed by the absorbing portion 110. Accordingly, due to the provision of the absorbing portion 110, it is possible to prevent incidence of light upon the second substrate 114, so that it is possible to prevent the generation of noise.

In a similar manner, the second ray bundle that has passed through the second pupil region 62 of the exit pupil 60 (refer to Fig. 5) is not required by the focus detection pixel 13 for phase difference detection. The second ray bundle that has passed through from the semiconductor layer 105 (i.e. from the photoelectric conversion unit 41) to the wiring layer 107 proceeds toward the second substrate 114 through the wiring layer 107. If light is incident from the wiring layer 107 upon the second substrate 114 just as it is, then there is a possibility that noise will be generated by this light being incident upon circuitry not shown in the figures provided on the second substrate 114. However, due to the provision of the absorbing portion 110 within the wiring layer 107, the light that has passed from the semiconductor layer 105 (i.e. from the photoelectric conversion unit 41) to the wiring layer 107 is absorbed by the absorbing portion 110. Accordingly, due to the provision of the absorbing portion 110, it is possible to prevent incidence of light upon the second substrate 114, so that it is possible to prevent the generation of noise.

According to the fourth embodiment described above, the following operations and beneficial effects are obtained.

(1) The image sensor 22 comprises the photoelectric conversion unit 41 that photoelectrically converts incident light and generates electric charge, the absorbing portion 110 that prevents reflection of at least a part of the light that has passed through the photoelectric conversion unit 41, and the reflecting portion 42A (42B) that reflects back part of the light that has passed through the photoelectric conversion units 41. Due to this, in a focus detection pixel 11, it is possible to suppress loss of light due to reflection when the light that has passed through the photoelectric conversion unit 41 and has been reflected by the reflecting portion 42A is again incident upon the photoelectric conversion unit 41, so that it is possible to suppress reduction of the signal S2' based upon the reflected light described above. Moreover, in a focus detection pixel 13, it is possible to suppress loss of light due to reflection when the light that has passed through the photoelectric conversion unit 41 and has been reflected by the reflecting portion 42B is again incident upon the photoelectric conversion unis 41, so that it is possible to suppress reduction of the signal S1' based upon the reflected light described above.

(2) With the image sensor 22 of (1) above, the reflection prevention layer 109 of the focus detection pixel 11 prevents reflection of light when light passes through the photoelectric conversion unit 41 and is incident upon the wiring layer 107, and prevents reflection of light when it is again incident from the wiring layer 107 upon the photoelectric conversion unit 41. Furthermore, the reflection prevention layer 109 of the focus detection pixel 13 prevents reflection of light when light passes through the photoelectric conversion unit 41 and is incident upon the wiring layer 107, and prevents reflection of light when it is again incident from the wiring layer 107 upon the photoelectric conversion unit 41. Due to this, along with it being possible to suppress reduction of the signal S2' based upon the light reflected in the focus detection pixel 11, also it is possible to suppress reduction of the signal S1' based upon the light reflected in the focus detection pixel 13.

(3) With the image sensor 22 of (1) or (2) above, the reflecting portion 42A of the focus detection pixel 11 reflects back a part of the light that has passed through its photoelectric conversion unit 41, and the reflecting portion 42B of the focus detection pixel 13 reflects back a part of the light that has passed through its photoelectric conversion unit 41. For example, the first and second ray bundles 651, 652 that have passed through the first and second pupil regions 61, 62 of the exit pupil 60 of the imaging optical system 31 (refer to Fig. 1) are incident upon the photoelectric conversion unit 41 of the focus detection pixel 11. And, among the second ray bundle 652 that is incident upon the photoelectric conversion unit 41, the reflecting portion 42A of the focus detection pixel 11 reflects back light that has passed through the photoelectric conversion unit 41. Moreover, the first and second ray bundles 651, 652 described above are incident upon the photoelectric conversion unit 41 of the focus detection pixel 13. And, among the first ray bundle 651 that is incident upon the photoelectric conversion unit 41, the reflecting portion 42B of the focus detection pixel 13 reflects back light that has passed through the photoelectric conversion unit 41. As a result, as phase difference information to be employed in pupil-split type phase difference detection, it is possible to obtain the signal S2' based upon reflected light in the focus detection pixel 11 and the signal S1' based upon reflected light in the focus detection pixel 13.

(4) With the image sensor 22 of (3) above, the focus detection pixel 11 has the absorbing portion 110 that absorbs light, among the light that has passed through the photoelectric conversion unit 41, that has not been reflected by the reflecting portion 42A. Moreover, the focus detection pixel 13 has the absorbing portion 110 that absorbs light, among the light that has passed through the photoelectric conversion unit 41, that has not been reflected by the reflecting portion 42B. With this structure, for example, it is possible to prevent generation of noise due to light that has not been reflected by the reflecting portions 42A, 42B being incident upon circuitry not shown in the figures provided upon the second substrates 114.

Embodiment Five

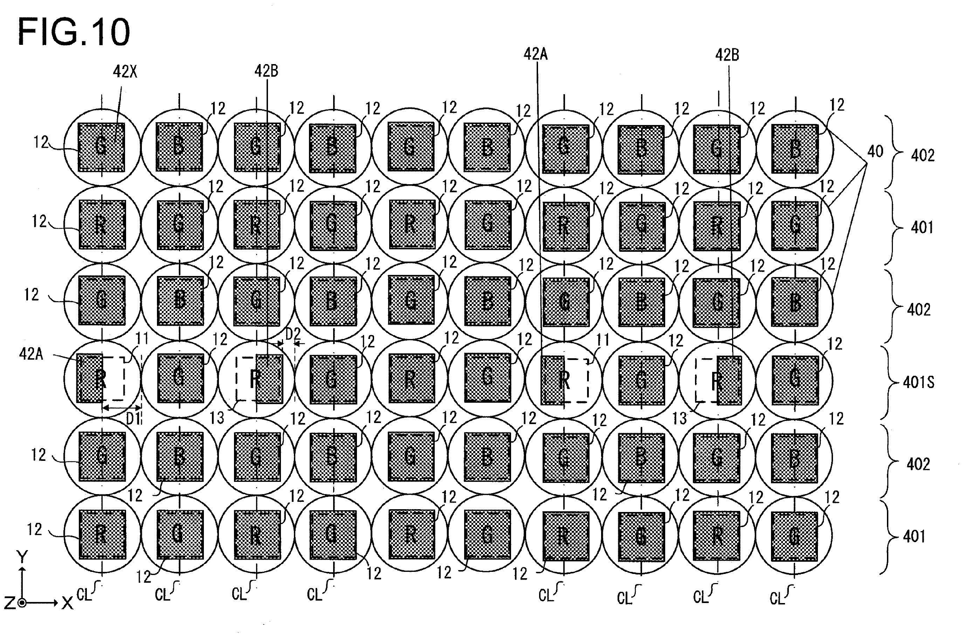

The reflection prevention countermeasures explained above in connection with the fourth embodiment are also effective when reflecting portions are provided to the imaging pixels 12. Fig. 10 is an enlarged sectional view of part of an array of pixels on an image sensor 22 according to a fifth embodiment. To structures that are the same as ones of Fig. 3, the same reference symbols are appended, and explanation thereof will be curtailed. As compared to Fig. 3 (for the first embodiment), the feature of difference is that reflecting portions 42X are also provided to all of the imaging pixels 12.

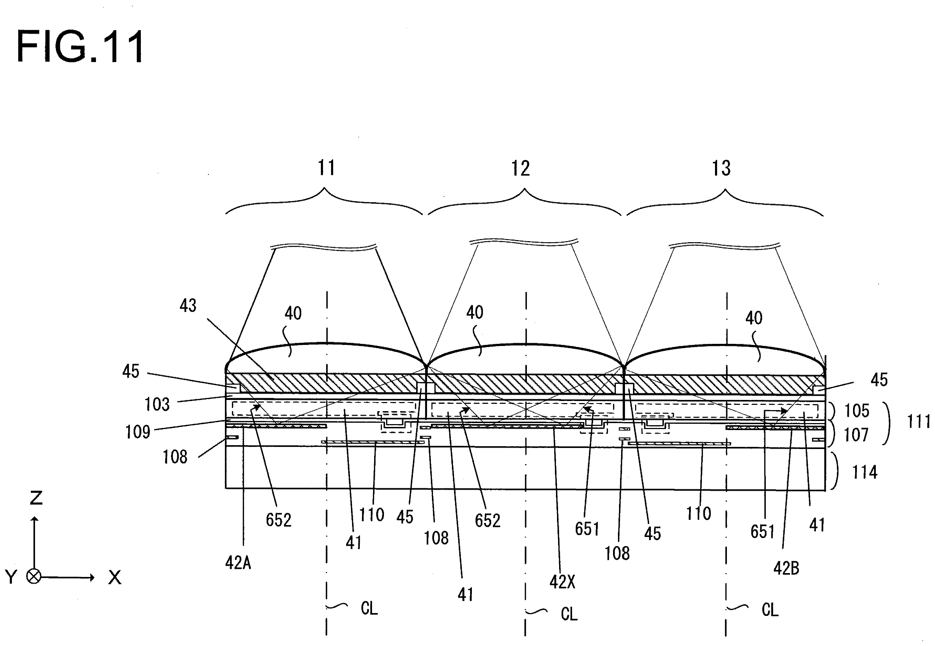

Fig. 11 is an enlarged sectional view of a single unit consisting of the focus detection pixels 11, 13 of Fig. 10 and an imaging pixel 12 sandwiched between them. This sectional view is a figure in which a single unit of Fig. 10 is cut parallel to the X-Z plane. To structures that are the same as ones of Fig. 6, the same reference symbols are appended, and explanation thereof will be curtailed.

In Fig. 11, the thickness of the semiconductor layer 105 in the Z axis direction is made to be thinner, as compared to the first embodiment through the fourth embodiment. In general, with the pupil-split type phase difference detection method, the detection accuracy of phase difference detection diminishes as the length of the optical path in the Z axis direction becomes longer, since the phase difference becomes smaller. Thus, from the standpoint of phase difference detection accuracy, it is desirable for the length of the optical path in the Z axis direction to be short.

For example, as miniaturization of the pixels of the image sensor 22 has progressed, the pixel pitch has become narrower. Progress of miniaturization without changing the thickness of the semiconductor layer 105 implies increase of the ratio of the thickness to the pixel pitch (i.e. of aspect ratio). Since miniaturization by simply narrowing the pixel pitch in this manner relatively lengthens the optical path length in the Z axis direction, accordingly this entails deterioration of the detection accuracy of the phase difference detection described above. However, if the thickness of the semiconductor layer 105 in the Z axis direction is reduced along with miniaturization of the pixels, then it is possible to prevent deterioration of the detection accuracy of phase difference detection.

On the other hand, there is a correlation relationship between the light absorptivity of the semiconductor layer 105 and the thickness of the semiconductor layer in the Z axis direction. The light absorptivity of the semiconductor layer 105 becomes greater as the thickness of the semiconductor layer in the Z axis direction increases, and becomes less as the thickness of the semiconductor layer in the Z axis direction decreases. Accordingly, making the thickness of the semiconductor layer 105 in the Z axis direction thinner invites a decrease in the light absorptivity of the semiconductor layer 105. Such a decrease in absorptivity may be said to be a decrease in the amount of electric charge generated by the photoelectric conversion unit 41 of the semiconductor layer 105. In general, when a silicon substrate is employed, it is necessary for the thickness of the semiconductor layer 105 to be from around 2 $\mu$m to around 3 $\mu$m in order to ensure reasonable absorptivity (for example 60% or greater) for red color light (of wavelength around 600 nm). At this time, the absorptivity for light of other colors is around 90% for green color light (of wavelength around 530 nm), and is around 100% for blue color light (of wavelength around 450 nm).

But, when the thickness of the semiconductor layer 105 is about half of the above, in other words is from around 1.25 $\mu$m to around 1.5 $\mu$m, then the absorptivity for red color light (of wavelength around 600 nm) decreases to around 35%. Moreover, the absorptivity for light of other colors decreases to around 65% for green color light (of wavelength around 530 nm), and to around 95% for blue color light (of wavelength around 450 nm). Accordingly, in the present embodiment, in order to compensate for the reduction in the amount of electric charge due to the reduction of the thickness of the semiconductor layer 105 in the Z axis direction, reflecting portions 42X are provided at the lower surfaces of the photoelectric conversion units 41 of the imaging pixels 12 (i.e. at their surfaces in the -Z axis direction).

The reflecting portions 42X of the imaging pixels 12 may, for example, be made from electrically conductive layer portions of copper, aluminum, tungsten or the like provided within the wiring layer 107, or from multiple insulating layers of silicon nitride or silicon oxide or the like. Although the reflecting portion 42X may cover the entire lower surface of the photoelectric conversion unit 41, there is no need for it necessarily to cover the entire lower surface of the photoelectric conversion unit 41. It will be sufficient, for example, for the area of the reflecting portion 42X to be wider than the image of the exit pupil 60 of the imaging optical system 31 that is projected upon the imaging pixel 12 by the micro lens 40, and for its position to be provided at a position where it reflects back the image of the exit pupil 60 without any loss.

For example, if it is supposed that the thickness of the semiconductor layer 105 is 3 $\mu$m, the refractive index of the semiconductor layer 105 is 4, the thickness of the organic film layer of the micro lens 40 and the color filter 43 and so on is 1 $\mu$m, the refractive index of the organic film layer is 1.5, and the refractive index in air is 1, then the spot size of the image of the exit pupil 60 projected upon the reflecting portion 42X of the imaging pixel 12 is around 0.5 $\mu$m when the aperture of the imaging optical system 31 is F2.8. And, if the thickness of the semiconductor layer 105 is reduced to around 1.5 $\mu$m, then the value of the spot size becomes smaller than in the above example.

Due to the provision of the reflecting portion 42X upon the lower surface of the photoelectric conversion unit 41 of the imaging pixel 12, the light that has proceeded in the downward direction through the photoelectric conversion unit 41 (i.e. in the -Z axis direction) and has passed through the photoelectric conversion unit 41 (i.e. that portion of the light that has not been absorbed) is reflected by the reflecting portion 42X and is again incident upon the photoelectric conversion unit 41 for a second time. This light that is again incident is photoelectrically converted by the photoelectric conversion unit 41 (i.e. is absorbed thereby). Due to this it is possible to increase the amount of electric charge generated by the photoelectric conversion unit 41, as compared with the case in which no such reflecting portion 42X is provided. To put it in another manner, it is possible to compensate for reduction of the amount of electric charge due to reduction of the thickness of the semiconductor layer 105 in the Z axis direction by the provision of the reflecting portion 42X. In this way, it is possible to improve the S/N ratio of the signal of the image read out from the imaging pixel 12.

Directing attention to the imaging pixel 12 of Fig. 11, the first ray bundle 651 that has passed through the first pupil region 61 of the exit pupil 60 of the imaging optical system 31 (refer to Fig. 5) and the second ray bundle 652 that has passed through its second pupil region (refer to Fig. 5) are both incident upon the photoelectric conversion unit 41 via the micro lens 40. Furthermore, the first and second ray bundles 651, 652 that are incident upon the photoelectric conversion unit 41 both pass through the photoelectric conversion unit 41 and are reflected by the reflecting portion 42X, and are again incident upon the photoelectric conversion unit 41 for a second time. In this manner, the imaging pixel 12 outputs a signal (S1+S2+S1'+S2') that is obtained by adding together signals S1 and S2 based upon electric charges obtained by photoelectrically converting the first ray bundle 651 and the second ray bundle 652 that have passed through the first and second pupil regions 61, 62 and have been incident upon the photoelectric conversion unit 41, and signals S1' and S2' based upon electric charges obtained by photoelectrically converting the first and second ray bundles that have been reflected by the reflecting portion 42X and have again been incident upon the photoelectric conversion unit 41 for a second time.

Furthermore, directing attention to the focus detection pixel 11, this focus detection pixel 11 outputs a signal (S1+S2+S2') that is obtained by adding together the above signals S1 and S2 based upon electric charges obtained by photoelectrically converting the first ray bundle 651 and the second ray bundle 652 that have passed through the first and second pupil regions 61, 62 and have been incident upon the photoelectric conversion unit 41, and the signal S2' based upon the electric charge obtained by photoelectrically converting that part, among the second ray bundle 652 that has passed through the photoelectric conversion unit 41, that has been reflected by the reflecting portion 42A and has again been incident upon the photoelectric conversion unit 41 for a second time.

Yet further, directing attention to the focus detection pixel 13, this focus detection pixel 13 outputs a signal (S1+S2+S1') that is obtained by adding together the above signals S1 and S2 based upon electric charges obtained by photoelectrically converting the first ray bundle 651 and the second ray bundle 652 that have passed through the first and second pupil regions 61, 62 and have been incident upon the photoelectric conversion unit 41, and the signal S1' based upon the electric charge obtained by photoelectrically converting that part, among the first ray bundle 651 that has passed through the photoelectric conversion unit 41, that has been reflected by the reflecting portion 42B and has again been incident upon the photoelectric conversion unit 41 for a second time.

It should be understood that, in the imaging pixel 12, in relation to the micro lens 40, for example, the position of the reflecting portion 42X and the position of the pupil of the imaging optical system 31 are mutually conjugate. In other words, the position of condensation of the light incident upon the imaging pixel 12 via the micro lens 40 is the reflecting portion 42X.

Moreover, in the focus detection pixels 11 (13), in relation to the micro lenses 40, for example, the position of the reflecting portions 42A (42B) and the position of the pupil of the imaging optical system 31 are mutually conjugate. In other words, the positions of condensation of the light incident upon the focus detection pixels 11 (13) via the micro lenses 40 are the reflecting portions 42A (42B).

Due to the reflecting portion 42X being provided to the imaging pixel 12, it is possible to provide micro lenses 40 having the same optical power to the imaging pixel 12 and to the focus detection pixels 11 (13). Accordingly it is not necessary to provide micro lenses 40 of different optical power or optical adjustment layers to the imaging pixel 12 and/or to the focus detection pixels 11 (13), so that it is possible to keep the manufacturing cost down.

Generation of the Image Data

The image generation unit 21b of the body control unit 21 generates image data related to an image of the photographic subject on the basis of the signal (S1+S2+S1'+S2') obtained from the imaging pixel 12 and the signals (S1+S2+S2') and (S1+S2+S1') obtained from the focus detection pixels 11, 13.

It should be understood that, during this generation of the image data, in order to suppress influence due to differences in the amount of electric charge generated by the photoelectric conversion unit 41 of the imaging pixel 12 and the amounts of electric charge generated by the focus detection pixels 11, 13, it would also be acceptable to apply differences between the gain applied to the signal (S1+S2+S1'+S2') from the imaging pixel 12, and the gains applied to the respective signals (S1+S2+S2') and (S1+S2+S1') from the focus detection pixels 11, 13. For example, the gains applied to the respective signals (S1+S2+S2') and (S1+S2+S1') from the focus detection pixels 11, 13 may be arranged to be larger, as compared to the gain applied to the signal (S1+S2+S1'+S2') from the imaging pixel 12.

Detection of the Amount of Image Deviation

The focus detection unit 21a of the body control unit 21 detects the amount of image deviation in the following manner, on the basis of the signal (S1+S2+S1'+S2') from the imaging pixel 12, the signal (S1+S2+S2') from the focus detection pixel 11, and the signal (S1+S2+S1') from the focus detection pixel 13. In other words, the focus detection unit 12 obtains a difference diff2B between the signal (S1+S2+S1'+S2') from the imaging pixel 12 and the signal (S1+S2+S2') from the focus detection pixel 11, and also obtains a difference diff1B between the signal (S1+S2+S1'+S2') from the imaging pixel 12 and the signal (S1+S2+S1') from the focus detection pixel 13. The difference diff1B corresponds to the signal S2' based upon the light, among the second ray bundle 652 that has passed through the photoelectric conversion unit 41 of the imaging pixel 12, that has been reflected by the reflecting portion 42A. In a similar manner, the difference diff2B corresponds to the signal S1' based upon the light, among the first ray bundle 651 that has passed through the photoelectric conversion unit 41 of the imaging pixel 12, that has been reflected by the reflecting portion 42B.

On the basis of the differences diff2B and diff1B, the focus detection unit 21a obtains the amount of image deviation between the image due to the first ray bundle 651 that has passed through the first pupil region 61, and the image due to the second ray bundle 652 that has passed through the second pupil region 62. In other words, by combining together the group of differences diff2B of signals respectively obtained from the plurality of units described above, and the group of differences diff1 B of signals respectively obtained from the plurality of units described above, the focus detection unit 21a obtains information specifying the intensity distributions of a plurality of images formed by a plurality of focus detection ray bundles that have respectively passed through the first pupil region 61 and the second pupil region 62.

The focus detection unit 21a calculates the amount of image deviation of this plurality of images described above by performing image deviation detection calculation processing (i.e. correlation calculation processing and phase difference detection method processing) upon the intensity distributions of the plurality of images. And the focus detection unit 21a further calculates an amount of defocusing by multiplying this amount of image deviation by a predetermined conversion coefficient. Calculation of an amount of defocusing according to a pupil-split type phase difference detection method such as described above is per se known.

Reflection Prevention

A reflection prevention layer 109 is provided to the image sensor 22 of this embodiment between the semiconductor layer 105 and the wiring layer 107, in a similar manner to the case with the fourth embodiment. Due to the provision of this reflection prevention layer 109, along with it being possible to suppress light reflection when light that has passed through the photoelectric conversion unit 41 of the semiconductor layer 105 is incident upon the wiring layer 107, also it is possible to suppress light reflection when light reflected back from the wiring layer 107 is again incident upon the photoelectric conversion unit 41.

Directing attention now to the imaging pixel 12, due to the provision of the reflection prevention layer 109, along with it becoming easier for light to pass through from the photoelectric conversion unit 41 to the wiring layer 107, also it becomes easier for light reflected back by the reflecting portion 42X of the wiring layer 107 to be again incident from the wiring layer 107 upon the photoelectric conversion unit 41. In addition to the signals S1 and S2, the signals S1' and S2' are also included in the image signals. These signals S1' and S2' are signals based upon the light, among the first ray bundle 651 and the second ray bundle 652 that have passed through the first and second pupil regions 61, 62 of the exit pupil 60, that is reflected by the reflecting portion 42X and is again incident upon the photoelectric conversion unit 41. If the transmission of light from the photoelectric conversion unit 41 to the wiring layer 107 is hampered (i.e. when reflection takes place between the photoelectric conversion unit 41 and the wiring layer 107 so that the optical transmittance is reduced), then the signals S1' and S2' obtained by the imaging pixel 12 are decreased. As a result, the S/N ratio of the image signals obtained by the imaging pixel 12 is reduced. However, with the present embodiment, due to the provision of the reflection prevention layer 109 between the semiconductor layer 105 and the wiring layer 107, it is possible to suppress the occurrence of reflection when light that has passed through the photoelectric conversion unit 41 is reflected by the reflecting portion 42X of the wiring layer 107 and is again incident upon the photoelectric conversion unit 41 for a second time. Thus, since it is possible to suppress reduction of the signals S1' and S2' described above due to reflection of light taking place between the semiconductor layer 105 and the wiring layer 107, accordingly it is possible to prevent reduction of the S/N ratio of the image signals. To put it in another manner, the reflection prevention layer 109 provided between the semiconductor layer 105 and the wiring layer 107 is also a film having high optical transmittance.

The operations and beneficial effects when the reflection prevention layer 109 is provided to the focus detection pixel 11 are as explained in connection with the fourth embodiment. In other words, light can easily be transmitted through from the photoelectric conversion unit 41 to the wiring layer 107. Due to this, it is possible to prevent deterioration of the accuracy of pupil-split type phase difference detection.

Furthermore, due to the provision of the reflection prevention layer 109 between the semiconductor layer 105 and the wiring layer 107, it is possible to suppress reflection of the first ray bundle 651 that is to pass through the photoelectric conversion unit 41, between the semiconductor layer 105 and the wiring layer 107. Due to this it is possible to suppress the occurrence of reflected light, which can constitute a cause of noise in the focus detection pixel 11, and it is possible to prevent deterioration of the accuracy of pupil-split type phase difference detection.

In a similar manner, the operations and beneficial effects of the provision of the reflection prevention layer 109 to the focus detection pixel 13 are as explained in connection with the fourth embodiment. In other words, light can easily be transmitted through from the photoelectric conversion unit 41 to the wiring layer 107. Due to this, it is possible to prevent deterioration of the accuracy of pupil-split type phase difference detection.

Yet further, due to the provision of the reflection prevention layer 109 between the semiconductor layer 105 and the wiring layer 107, it is possible to suppress reflection of the second ray bundle 652 that is to pass through the photoelectric conversion unit 41, between the semiconductor layer 105 and the wiring layer 107.

Due to this it is possible to suppress the occurrence of reflected light, which can constitute a cause of noise in the focus detection pixel 13, and it is possible to prevent deterioration of the accuracy of pupil-split type phase difference detection.

It should be understood that, in Fig. 11, the absorbing portion 110 within the wiring layer 107 is provided so that light should not be incident from the wiring layer 107 upon the second substrate 114. The reason for this is, in a similar manner to the case with the fourth embodiment, in order to prevent the occurrence of noise due to incidence of light upon circuitry not shown in the figures provided upon the second substrate 114.

According to the fifth embodiment described above, the following operations and beneficial effects are obtained.

(1) As an addition to the image sensor 22 of the fourth embodiment, there are provided a photoelectric conversion unit 41 that performs photoelectric conversion upon incident light and generates electric charge, a reflecting portion 42X that reflects back light that has passed through the photoelectric conversion unit 41, and a reflection prevention layer 109 that is provided between the photoelectric conversion unit 41 and the reflecting portion 42X. Due to this, when in the imaging pixel 12 light passes through the photoelectric conversion element 41 and is reflected back again by the reflecting portion 42X and is again incident upon the photoelectric conversion unit 41 for a second time, loss of light due to reflection when it is again incident upon the photoelectric conversion unit 41 can be suppressed, so that it is possible to suppress decrease of the signal (S1'+S2') based upon the reflected light.

(2) In the image sensor 22 of (1) above, the reflection prevention layer 109 of the imaging pixel 12 suppresses light reflection when light that has passed through the photoelectric conversion unit 41 is incident upon the wiring layer 107, and suppresses light reflection when light is reflected from the wiring layer 107 and is again incident upon the photoelectric conversion unit 41. Due to this, with this imaging pixel 12, it is possible to suppress decrease of the signal (S1'+S2') based upon the reflected light described above.

Embodiment Six

In a sixth embodiment of the present invention, the reflection prevention layer 109 provided between the semiconductor layer 105 and the wiring layer 107 in the fourth and fifth embodiments described above will be explained with attention particularly being directed to the relationship with light wavelength. In general, the thickness of the reflection prevention layer 109 should be arranged to be an odd multiple of $\lambda/4$. Here, $\lambda$ is the wavelength of the light in question. For example, if the focus detection pixels 11, 13 are disposed at positions of R pixels, then the thickness of the reflection prevention layer 109 is designed based upon the wavelength of red color light (around 600 nm). By doing this, it is possible to make the reflectivity for incident red color light appropriately low. To put it in another manner, it is possible to make the transmittance for incident red color light appropriately high.

It should be understood that, if the focus detection pixels 11, 13 are disposed at positions of G pixels, then the thickness of the reflection prevention layer 109 is designed based upon the wavelength of green color light (around 530 nm).

In order to lower the optical reflectivity, it will also be acceptable to apply a multi-coating, and thereby to manufacture the reflection prevention layer 109 as a multi-layer structure. By implementing such a multi-layer structure, it is possible further to lower the reflectivity, as compared to the case of a single-layer structure.

Moreover, the use of multi-coating is also effective when lowering the reflectivity of light of a plurality of wavelengths. For example, the imaging pixels 12 of the fifth embodiment (refer to Fig. 10) are arranged as R pixels, G pixels, and B pixels. In this case, there is a requirement to make the reflectivity for red color light at the positions of R pixels low, to make the reflectivity for green color light at the positions of G pixels low, and to make the reflectivity for blue color light at the positions of B pixels low. For example, it would be acceptable to arrange to provide reflection prevention layers 109 of different wavelengths for each pixel matched to the spectral characteristics of the color filters 43 provided to the imaging pixels 12, or to apply multi-coatings to all the pixels in order to lower their optical reflectivities at a plurality of wavelengths.

For example, it is possible to keep the reflectivities at R, G, and B wavelengths low by providing reflection prevention layers of multi-layered structure in which films designed on the basis of the wavelength of red color light (about 600 nm), the wavelength of green color light (about 530 nm), and the wavelength of blue color light (about 450 nm) are laminated together. This is appropriate when it is desired to manufacture reflection prevention layers 109 for all of the pixels by the same process.

According to the sixth embodiment described above, the following operations and beneficial effects are obtained.

(1) As an addition to the image sensor 22 of the fourth or the fifth embodiment described above, the reflection prevention layer 109 of the focus detection pixel 11 suppresses the reflection of light in the wavelength region that is incident upon the focus detection pixel 11 (for example of red color light), and moreover the reflection prevention layer 109 of the focus detection pixel 13 suppresses the reflection of light in the wavelength region that is incident upon the focus detection pixel 13 (for example of red color light).

Due to this, it is possible to suppress reflection of light in the incident wavelength region in an appropriate manner.

(2) In the image sensor 22 of (1) above, light of the wavelength region that is determined in advance is incident upon the focus detection pixel 11 and upon the focus detection pixel 13, and the reflection prevention layers 109 suppress reflection at least of light in the wavelength region mentioned above. For example, at the positions of R pixels, G pixels, and B pixels that are arranged according to a Bayer array, the wavelength region that lowers the reflectivity at the reflection prevention layers 109 and is matched to the spectral characteristics of the color filters 43 that are provided to the focus detection pixels 11 and to the focus detection pixels 13, is determined in advance. Due to this, it is possible to suppress reflection of light in the incident wavelength regions in an appropriate manner.

(3) As additions to the image sensor 22 described above, reflection prevention layers 109 of the imaging pixels 12 suppress reflection of light in the wavelength regions of the light that is incident upon the imaging pixels 12. Due to this, it is possible to suppress reflection of light in the incident wavelength regions in an appropriate manner.

(4) In the image sensor 22 of (3) above, light of wavelength regions that are determined in advance is incident upon the imaging pixels 12, and the reflection prevention layers 109 suppress reflection of light of at least those wavelength regions mentioned above. For example, at the positions of R pixels, G pixels, and B pixels that are arranged according to a Bayer array, the wavelength regions that lower the reflectivity at the reflection prevention layers 109 and are matched to the spectral characteristics of the color filters 43 that are provided to the imaging pixels 12, are determined in advance. Due to this, it is possible to suppress reflection of light in the incident wavelength regions in an appropriate manner.

There is no requirement for the reflection prevention layers 109 described above necessarily to cover the entire lower surfaces of the photoelectric conversion units 41 (i.e. their surfaces in the -Z axis direction), as shown in Fig. 9 and Fig. 11. For example, the reflection prevention layers 109 may be provided only upon the portions of the lower surfaces of the photoelectric conversion units where the reflecting portions 42A, 42B, 42X are not provided. Or, in the focus detection pixel 11, the reflecting portion 42A may be only provided on the right side of the line CL (i.e. on its side toward the +X axis direction). In a similar manner, in the focus detection pixel 13, the reflecting portion 42B may be only provided on the left side of the line CL (i.e. on its side toward the -X axis direction).

Furthermore, the reflection prevention layers 109 that are provided upon the portions where the reflecting portions 42A, 42B, and 42X are not provided may also be absorbing portions that absorb light.

It would also be acceptable to provide light shielding portions between neighboring ones of the photoelectric conversion units 41. For example, light shielding portions may be provided between the photoelectric conversion units 41 of the focus detection pixels 11 and the photoelectric conversion units 41 of the imaging pixels 12, or between the photoelectric conversion units 41 of the focus detection pixels 13 and the photoelectric conversion units 41 of the imaging pixels 12, or between the photoelectric conversion units 41 of the plurality of imaging pixels 12. Such light shielding portions may, for example, be made by DTI (Deep Trench Isolation). A groove is formed between the two pixels in question, and an oxide layer, a nitride layer, polysilicon, or the like is embedded into this groove. Since such light shielding portions are provided between neighboring ones of the photoelectric conversion units 41, accordingly it is possible to suppress light reflected by the reflecting portions 42A or the reflecting portions 42B from being incident upon adjacent pixels. Due to this, it is possible to suppress crosstalk. Moreover, the light shielding portions described above may also be reflecting portions. Since such reflecting portions cause light to be again incident back upon the photoelectric conversion units 41, accordingly the sensitivity of the photoelectric conversion units 41 is enhanced. In this way, it is possible to enhance the accuracy of focus detection.

Directions of Arrangement of the Focus Detection Pixels

In the embodiments and the variant embodiments described above, it would also be acceptable to vary the directions in which the focus detection pixels are arranged, in the following ways.

In general, when performing focus detection upon a pattern on a photographic subject that extends in the vertical direction, it is preferred for the focus detection pixels to be arranged along the row direction (i.e. the X axis direction), in other words along the horizontal direction. Moreover, when performing focus detection upon a pattern on a photographic subject that extends in the horizontal direction, it is preferred for the focus detection pixels to be arranged along the column direction (i.e. the Y axis direction), in other words along the vertical direction. Accordingly, in order to perform focus detection irrespective of the direction of the pattern of the photographic subject, it is desirable to have both focus detection pixels that are arranged along the horizontal direction and also focus detection pixels that are arranged along the vertical direction.

Accordingly, for example, in the focusing areas 101-1 through 101-3 of Fig. 2, the focus detection pixels 11, 13 are arranged along the horizontal direction. Moreover, for example, in the focusing areas 101-4 through 101-11, the focus detection pixels 11, 13 are arranged along the vertical direction. By providing a structure of this type, it is possible to arrange the focus detection pixels of the image sensor 22 both along the horizontal direction and along the vertical direction.

It should be understood that, if the focus detection pixels 11, 13 are arranged along the vertical direction, then the reflecting portions 42A, 42B of the focus detection pixels 11, 13 are arranged so as, respectively, to correspond to regions almost at the lower halves (i.e. toward the -Y axis sides thereof) and to regions almost at the upper halves (i.e. towards the +Y axis sides thereof) of their corresponding photoelectric conversion units 41. In the XY plane, at least portions of the reflecting portions 42A of the focus detection pixels 11 are, for example, provided in regions that, among regions divided by a line orthogonal to the line CL and parallel to the X axis in Fig. 4 etc., are toward the -Y axis direction. Similarly, in the XY plane, at least portions of the reflecting portions 42B of the focus detection pixels 13 are, for example, provided in regions that, among regions divided by a line orthogonal to the line CL and parallel to the X axis in Fig. 4, are toward the +Y axis direction.

By arranging the focus detection pixels both along the horizontal direction and also along the vertical direction in this manner, it becomes possible to perform focus detection irrespective of the direction of the pattern upon the photographic subject.

It should be understood that, in the focusing areas 101-1 through 101-11 of Fig. 2, it would also be acceptable to arrange the focus detection pixels 11, 13 along the horizontal direction and along the vertical direction. By providing such an arrangement, it would become possible to perform focus detection irrespective of the direction of the pattern upon the photographic subject with any of the focusing areas 101-1 through 101-11.

While various embodiments and variant embodiments have been explained above, the present invention is not to be considered as being limited to the details thereof. Other variations that are considered to come within the range of the technical concept of the present invention are also included within the scope of the present invention.

The content of the disclosure of the following application, upon which priority is claimed, is herein incorporated by reference.

Japanese Patent Application No. 2017-63652 (filed on March 28, 2017).

REFERENCE SIGNS LIST

1: camera
2: camera body
3: interchangeable lens
11, 13: focus detection pixels
12: imaging pixel
21: body control unit
21a: focus detection unit
22: image sensor
31: imaging optical system
40: micro lens
41: photoelectric conversion unit
42A, 42B, 42X: reflecting portions
43: color filter
44: gradient-index lens
60: exit pupil
61: first pupil region
62: second pupil region
109: reflection prevention layer
110: absorbing portion
401, 401S, 402: pixel rows
CL: line passing through center of pixel (for example, through center of photoelectric conversion unit)

**Claims**

1. An image sensor, comprising:

   a photoelectric conversion unit that photoelectrically converts incident light and generates electric charge;
   a reflection prevention portion that prevents reflection of at least a portion of light passing through the photoelectric conversion unit; and
   a reflecting portion that reflects a portion of light passing through the photoelectric conversion unit toward the photoelectric conversion unit.

2. The image sensor according to claim 1, wherein:
   the photoelectric conversion unit, the reflection prevention portion, and the reflecting portion are provided in order from a side where light is incident.

3. The image sensor according to claim 1 or claim 2, wherein:
   the reflection prevention portion prevents reflection when light that has been reflected by the reflecting portion is incident upon the photoelectric conversion unit.

4. The image sensor according to any one of claims 1 through 3, wherein:
   the reflection prevention portion prevents reflection of light of shorter wavelength than light that has passed through the photoelectric conversion unit.

5. The image sensor according to any one of claims 1 through 4, further comprising:
   a filter that passes light of a specified wavelength region, wherein:
   the reflection prevention portion prevents reflection of light of other than the specified wavelength region, among light that has passed through the filter and through the photoelectric conversion unit.

**6.** The image sensor according to any one of claims 1 through 5, wherein:
the reflecting portion reflects a portion of light that has passed through the photoelectric conversion unit and the reflection prevention portion, back to the photoelectric conversion unit.

**7.** The image sensor according to any one of claims 1 through 6, further comprising:
an absorbing portion that absorbs light that has not been reflected by the reflecting portion.

**8.** The image sensor according to any one of claims 1 through 6, further comprising:
an absorbing portion that absorbs light that has passed through the reflection prevention portion.

**9.** The image sensor according to any one of claims 1 through 8, comprising:
a first pixel and a second pixel each of which comprises the photoelectric conversion unit and the reflecting portion, wherein:

the first pixel and the second pixel are arranged along a first direction;
at least a part of the reflecting portion of the first pixel is provided in a region more toward the first direction than a center of the photoelectric conversion unit of the first pixel; and
at least a part of the reflecting portion of the second pixel is provided in a region more toward a direction opposite to the first direction than a center of the photoelectric conversion unit of the second pixel.

**10.** The image sensor according to claim 9, wherein:

the first pixel and the second pixel each have the reflection prevention portion;
in a plane that intersects a direction in which light is incident, at least a portion of the reflection prevention portion of the first pixel is provided in a region more toward a direction opposite to the first direction than the center of the photoelectric conversion unit of the first pixel; and
in a plane that intersects a direction in which light is incident, at least a portion of the reflection prevention portion of the second pixel is provided in a region more toward the first direction than the center of the photoelectric conversion unit of the second pixel.

**11.** The image sensor according to claim 9 or claim 10, further comprising:
a third pixel comprising the photoelectric conversion unit and the reflection prevention portion.

**12.** The image sensor according to claim 11, wherein:

the third pixel comprises the reflecting portion that reflects light passing through the photoelectric conversion unit and the reflection prevention portion back toward the photoelectric conversion unit.

**13.** The image sensor according to any one of claims 9 through 12, further comprising:
a fourth pixel comprising the photoelectric conversion unit, wherein:

the first pixel and the second pixel each have a first filter having first spectral characteristics; and
the fourth pixel has a second filter having second spectral characteristics whose transmittance for light of short wavelength is higher than the first spectral characteristics.

**14.** An imaging device, comprising:

an image sensor according to claim 9 or claim 10; and
a control unit that, based upon a signal outputted from the first pixel and a signal outputted from the second pixel of the image sensor that captures an image formed by an optical system having a focusing lens, controls a position of the focusing lens so that the image formed by the optical system is focused upon the image sensor.

**15.** An imaging device, comprising:

an image sensor according to claim 11 or claim 12; and
a control unit that, based upon a signal outputted from the first pixel, a signal outputted from the second pixel, and a signal outputted from the third pixel of the image sensor that captures an image formed by an optical system having a focusing lens, controls a position of the focusing lens so that the image formed by the optical system is focused upon the image sensor.

# FIG.1

# FIG.2

90

101-1

101-8

101-10

101-4  101-5  101-2  101-6  101-7

101-9  101-11

101-3

## FIG.3

# FIG.4

(a)

(b)

(c)

# FIG.5

FIG.6

(b)

# FIG.7

(a)

(b)

# FIG.8

(a)

(b)

# FIG.9

(a)

(b)

FIG.10

EP 3 605 609 A1

# FIG.11

## INTERNATIONAL SEARCH REPORT

| International application No. |
| --- |
| PCT/JP2018/012987 |

**A. CLASSIFICATION OF SUBJECT MATTER**
Int.Cl. H01L27/146(2006.01)i, H04N5/369(2011.01)i

According to International Patent Classification (IPC) or to both national classification and IPC

**B. FIELDS SEARCHED**

Minimum documentation searched (classification system followed by classification symbols)
Int.Cl. H01L27/146, H04N5/369

Documentation searched other than minimum documentation to the extent that such documents are included in the fields searched

| | |
| --- | --- |
| Published examined utility model applications of Japan | 1922-1996 |
| Published unexamined utility model applications of Japan | 1971-2018 |
| Registered utility model specifications of Japan | 1996-2018 |
| Published registered utility model applications of Japan | 1994-2018 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| Y | JP 2016-127043 A (SONY CORP.) 11 July 2016, paragraphs [0001], [0044], [0046], [0048], [0126], [0219], fig. 1-18 (Family: none) | 1-15 |
| Y | JP 2013-65831 A (CANON INC.) 11 April 2013, paragraphs [0009], [0011]-[0016], [0019], fig. 1-8 & US 2014/0035086 A1, paragraphs [0016], [0018]-[0023], [0026], fig. 1-8 & WO 2013/031708 A1 | 1-15 |
| Y | JP 2014-96540 A (CANON INC.) 22 May 2014, paragraph [0015], fig. 1-13 & US 2014/0132812 A1, paragraph [0030], fig. 1-13 | 7-15 |
| A | WO 2010/100897 A1 (PANASONIC CORP.) 10 September 2010, paragraph [0033], fig. 1-13 & US 2011/0115919 A1, paragraph [0048], fig. 1-13 | 1-15 |

☐ Further documents are listed in the continuation of Box C.　　☐ See patent family annex.

| | |
| --- | --- |
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
| --- | --- |
| 11 June 2018 (11.06.2018) | 19 June 2018 (19.06.2018) |

| Name and mailing address of the ISA/ | Authorized officer |
| --- | --- |
| Japan Patent Office<br>3-4-3, Kasumigaseki, Chiyoda-ku,<br>Tokyo 100-8915, Japan | |
| | Telephone No. |

Form PCT/ISA/210 (second sheet) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2016127043 A
- JP 2017063652 A